# EUROPEAN PATENT APPLICATION

(11) **EP 4 741 222 A1**
(43) Date of publication of application: **13.05.2026**
(21) Application number: 24844195.8
(22) Date of filing: 05.02.2024
(51) Int. Cl.: B60L 58/18

(54) **POWER-ON METHOD OF BATTERY SYSTEM, BATTERY SYSTEM, AND ELECTRIC DEVICE**

(30) Priority: 27.07.2023 CN 202310936376
(71) Applicant: Contemporary Amperex Technology Co., Limited, Ningde, Fujian 352100 (CN)
(72) Inventor: WU, Kai, Ningde, Fujian 352100 (CN); YANG, Zhengxing, Ningde, Fujian 352100 (CN); CHAN, Libing, Ningde, Fujian 352100 (CN)
(74) Representative: Kraus & Lederer PartGmbB
(86) International application number: PCT/CN2024/075934
(87) International publication number: WO 2025/020496

(57) **Abstract**

A power-on method of a battery system, a battery system, and an electric device, capable of improving the battery swapping performance of the battery system. The battery system comprises a plurality of battery swapping units connected in parallel, wherein each battery swapping unit comprises a battery and a first battery management unit thereof, and the battery system further comprises second battery management units connected to the first battery management units in the plurality of battery swapping units. The power-on method is executed by the second battery management units. The power-on method comprises: receiving a first power-on signal sent by a vehicle control unit; and in response to the first power-on signal, sending to the first battery management unit a second power-on signal, wherein the second power-on signal is used for instructing each first battery management unit to control the corresponding battery swapping unit to perform high-voltage power-on.

## Description

The present application claims priority to Chinese Patent Application No. 202310936376.2, filed with China National Intellectual Property Administration on July 27, 2023 and entitled "POWER-ON METHOD FOR BATTERY SYSTEM, BATTERY SYSTEM, AND ELECTRIC APPARATUS", the content of which is incorporated herein by reference in its entirety.

### TECHNICAL FIELD

The present application relates to the field of batteries, and in particular, to a power-on method for a battery system, a battery system, and an electric apparatus.

### BACKGROUND

A battery swapping station enables rapid battery swapping for an electric vehicle. However, with the increasing number of battery packs in the electric vehicle and more flexible distribution positions of such battery packs, how to improve the battery swapping performance of the electric vehicle has become an urgent problem to be addressed.

### SUMMARY

Embodiments of the present application provide a power-on method for a battery system, a battery system, and an electric apparatus, which can improve the battery swapping performance of the battery system.

In a first aspect, a power-on method for a battery system is provided. The battery system includes a plurality of battery swapping units connected in parallel, where each battery swapping unit includes a battery and a first battery management unit of the battery, the battery system further includes a second battery management unit connected to the first battery management units in the plurality of battery swapping units, the power-on method is performed by the second battery management unit, and the power-on method includes: receiving a first power-on signal sent by a vehicle control unit; and in response to the first power-on signal, sending a second power-on signal to the first battery management unit, where the second power-on signal is used to instruct the first battery management unit to control a corresponding battery swapping unit to perform high-voltage power-on.

The battery system according to the present application includes a plurality of battery swapping units, each battery swapping unit includes a battery and a corresponding first battery management unit, and the first battery management units in the plurality of battery swapping units are all connected to the second battery management unit. Therefore, the plurality of battery swapping units do not need to be bound for use, allowing only a portion of the battery swapping units to be swapped and charged. This supports the mixed use of the battery swapping units, thereby resulting in high battery swapping efficiency and facilitating the construction and operation of the battery swapping station. When the battery system is subject to the high-voltage power-on, the second battery management unit may receive the first power-on signal sent by the vehicle control unit, and send, in response to the first power-on signal, the second power-on signal to the first battery management unit, such that the first battery management unit controls a corresponding battery swapping unit to perform high-voltage power-on, thereby effectively achieving the high-voltage power-on of the battery system.

In a possible implementation, the power-on method further includes: determining a number of the plurality of battery swapping units, where sending the second power-on signal to the first battery management unit includes: in a case where the number of the plurality of battery swapping units is equal to a preset number, sending the second power-on signal to the first battery management unit.

Determining whether the number of the battery swapping units is equal to the preset number before the high-voltage power-on can reduce the risks caused by problems such as failure of the battery swapping units and improve the reliability of the power-on process of the battery system.

In a possible implementation, determining the number of the plurality of battery swapping units includes: sending an encoding signal to a first battery management unit of a first battery swapping unit among the plurality of battery swapping units, where the encoding signal is used to be sequentially transmitted among the first battery management units in the plurality of battery swapping units, so as to sequentially encode the plurality of battery swapping units; receiving an encoding result sent by a first battery management unit of a last battery swapping unit among the plurality of battery swapping units; and determining, based on the encoding result, the number of the plurality of battery swapping units.

In this implementation, the encoding signal is sent to the first battery management unit of the first battery swapping unit, and the encoding signal is sequentially delivered among the plurality of battery swapping units until the first battery management unit of the last battery swapping unit receives the encoding signal, so as to encode the plurality of battery swapping units. The second battery management unit receives the encoding result sent by the first battery management unit of the last battery swapping unit, thereby determining whether the current number of battery swapping units is the preset number.

In a possible implementation, sending the second power-on signal to the first battery management unit includes: determining at least one battery swapping unit to be powered on among the plurality of battery swapping units; and sending the second power-on signal to a first battery management unit in the at least one battery swapping unit.

To reduce the risk existing in the battery system, the second battery management unit may determine, based on the actual situation of each battery swapping unit, whether to perform high-voltage power-on on each battery swapping unit.

In a possible implementation, determining the at least one battery swapping unit to be powered on among the plurality of battery swapping units includes: determining, based on voltages of the plurality of battery swapping units, the at least one battery swapping unit to be powered on among the plurality of battery swapping units.

The second battery management unit may determine, based on the voltage condition of each battery swapping unit, whether to perform high-voltage power-on on each battery swapping unit, so as to reduce the risk existing in the battery system.

In a possible implementation, determining, based on the voltages of the plurality of battery swapping units, the at least one battery swapping unit to be powered on among the plurality of battery swapping units includes: in a case where a voltage difference between a highest-voltage battery swapping unit and a lowest-voltage battery swapping unit among the plurality of battery swapping units is greater than or equal to a voltage threshold, determining that the at least one battery swapping unit includes a battery swapping unit having a voltage difference from the highest-voltage battery swapping unit less than the voltage threshold.

In this implementation, in the case where the voltage difference between the highest-voltage battery swapping unit and the lowest-voltage battery swapping unit among the plurality of battery swapping units is greater than or equal to the voltage threshold, in order to reduce the risk existing in the battery system, it is possible to select only the battery swapping unit having a voltage difference from the highest-voltage battery swapping unit within a predetermined range as the battery swapping unit that requires high-voltage power-on.

In a possible implementation, determining, based on the voltages of the plurality of battery swapping units, the at least one battery swapping unit to be powered on among the plurality of battery swapping units includes: in a case where the voltage difference between the highest-voltage battery swapping unit and the lowest-voltage battery swapping unit among the plurality of battery swapping units is less than or equal to the voltage threshold, determining that the at least one battery swapping unit includes the plurality of battery swapping units.

In this implementation, since the voltage difference between the highest-voltage battery swapping unit and the lowest-voltage battery swapping unit among the plurality of battery swapping units is less than or equal to the voltage threshold, the voltage differences between other battery swapping units and the highest-voltage battery swapping unit are also less than or equal to the voltage threshold, such that high-voltage power-on can be performed simultaneously on the plurality of battery swapping units.

In a possible implementation, the battery swapping unit further includes a slave high-voltage box connected to the battery, and the slave high-voltage box includes a first relay unit, where the second power-on signal is specifically used to instruct the first battery management unit to control a corresponding first relay unit to close.

The first relay unit may include, for example, a main positive relay and/or a main negative relay on the main loop of a battery, and the second power-on signal is used to instruct the first battery management unit of the battery swapping unit to be powered on to control the first relay unit in the corresponding battery swapping unit to close, thereby achieving high-voltage power-on on the battery swapping unit.

In a possible implementation, the battery system further includes a master high-voltage box, the slave high-voltage box is connected to the master high-voltage box via a pluggable electrical connector, the master high-voltage box includes a second relay unit, and the power-on method further includes: controlling the second relay unit to close after the first relay unit in the at least one battery swapping unit is closed.

After the first relay units in the slave high-voltage boxes of the respective battery swapping units to be powered on are all closed, the second battery management unit controls the second relay unit in the master high-voltage box to close, such that the energy provided by the batteries of the respective battery swapping units can simultaneously reach the high-voltage electric device, thereby providing a more stable high-voltage signal for the high-voltage electric device.

In a possible implementation, the power-on method further includes: sending a power-on completion signal to the vehicle control unit after the second relay unit is closed.

Upon completion of the high-voltage power-on, the second battery management unit needs to notify the vehicle control unit that the battery side has completed the high-voltage power-on, such that the vehicle control unit controls the vehicle side to perform the high-voltage power-on.

In a possible implementation, the power-on method further includes: sending information on an allowable power of the battery system, where the allowable power of the battery system is a sum of allowable powers of the plurality of battery swapping units, thereby facilitating charging and discharging between an external device and the battery system and improving the reliability of the charging and discharging process.

In a possible implementation, the power-on method further includes: receiving a wake-up signal; and performing, based on the wake-up signal, low-voltage power-on on the second battery management unit. Since the second battery management unit, the first battery management unit, and the like need a low-voltage signal as a power supply, before the second battery management unit controls the battery system to perform high-voltage power-on, the second battery management unit needs to perform, based on the received wake-up signal, low-voltage power-on.

In a second aspect, a power-on method for a battery system is provided. The battery system includes a plurality of battery swapping units connected in parallel, where each battery swapping unit includes a battery and a first battery management unit of the battery, the battery system further includes a second battery management unit connected to the first battery management units in the plurality of battery swapping units, the power-on method is performed by a vehicle control unit, and the power-on method includes: determining whether the battery system meets a high-voltage power-on condition; and in a case where the high-voltage power-on condition is met, sending a first power-on signal to the second battery management unit, where the first power-on signal is used to instruct the second battery management unit to control the battery system to perform high-voltage power-on.

The battery system according to the present application includes a plurality of battery swapping units, each battery swapping unit includes a battery and a corresponding first battery management unit, and the first battery management units in the plurality of battery swapping units are all connected to the second battery management unit. Therefore, the plurality of battery swapping units do not need to be bound for use, allowing only a portion of the battery swapping units to be swapped and charged. This supports the mixed use of the battery swapping units, thereby resulting in high battery swapping efficiency and facilitating the construction and operation of the battery swapping station. When the battery system is subject to the high-voltage power-on, the vehicle control unit sends the first power-on signal to the second battery management unit, thereby controlling, via the second battery management unit, the battery system to perform high-voltage power-on, thereby effectively achieving high-voltage power-on of the battery system.

For example, the high-voltage power-on condition includes at least one of the following: relays in the battery system are all in an off state; and the high-voltage electric device connected to the battery system is not enabled.

In a possible implementation, the power-on method further includes: receiving a power-on completion signal sent by the second battery management unit, where the power-on completion signal is used to indicate that the battery system has completed high-voltage power-on; and controlling, based on the power-on completion signal, a relay in a main loop between the battery system and the high-voltage electric device to close.

Upon receiving the power-on completion signal sent by the second battery management unit and determining that the battery system has completed the high-voltage power-on, the vehicle control unit controls the relay in the main loop between the battery system and the high-voltage electric device to close; that is, high-voltage power-on is first performed on the battery system, and then high-voltage power-on is performed on the high-voltage electric device, so as to reduce the risk caused by situations such as sudden startup of the high-voltage electric device.

In a possible implementation, the power-on method further includes: receiving a wake-up signal; and performing, based on the wake-up signal, low-voltage power-on on the vehicle control unit. Since the vehicle control unit and the like need a low-voltage signal as a power supply, before the vehicle control unit controls the high-voltage electric device to perform high-voltage power-on, the vehicle control unit needs to perform, based on the received wake-up signal, low-voltage power-on.

In a third aspect, a battery system is provided. The battery system includes: a plurality of battery swapping units connected in parallel, where each battery swapping unit includes a battery and a slave high-voltage box connected to the battery, and the slave high-voltage box includes a first battery management unit of the battery; and a master high-voltage box, where the slave high-voltage box is connected to the master high-voltage box via a pluggable electrical connector, and the master high-voltage box includes a second battery management unit connected to the first battery management units in the plurality of battery swapping units.

The battery system according to the present application includes a plurality of battery swapping units, each battery swapping unit is provided with a battery and a slave high-voltage box connected to the battery, a corresponding first battery management unit is provided in the slave high-voltage box, the battery system is further provided with a master high-voltage box connected to the slave high-voltage box of each battery swapping unit, and a second battery management unit connected to the first battery management unit in each slave high-voltage box is provided in the master high-voltage box. Since a three-tier architecture formed by a cell sampling circuit, the first battery management unit, and the second battery management unit is adopted, during the battery swapping process, the battery swapping units can be disconnected via the pluggable electrical connectors between the slave high-voltage boxes and the master high-voltage box of the battery swapping units. Therefore, the plurality of battery swapping units can be disassembled independently, and the plurality of battery swapping units do not need to be bound for use, allowing only a portion of the battery swapping units to be swapped and charged. This supports the mixed use of the battery swapping units, thereby resulting in high battery swapping efficiency, facilitating the construction and operation of the battery swapping station, and expanding the battery swapping scenarios applicable to the battery system.

In a possible implementation, the electrical connector includes a high-voltage interface and a low-voltage interface, a high-voltage line in the slave high-voltage box is connected to a high-voltage line in the master high-voltage box via the high-voltage interface, and a low-voltage line in the slave high-voltage box is connected to a low-voltage line in the master high-voltage box via the low-voltage interface.

The electrical connector includes the high-voltage interface and the low-voltage interface to enable a high-voltage connection and a low-voltage connection between the slave high-voltage box and the master high-voltage box.

In a possible implementation, the master high-voltage box and/or the slave high-voltage box further includes an insulation detector, the insulation detector is configured to detect insulation impedance to ground of a high-voltage bus, and the insulation detector in the master high-voltage box and the insulation detector in the slave high-voltage box are configured to be prevented from being enabled simultaneously.

In this implementation, the insulation detectors in the master high-voltage box and the slave high-voltage box are configured to be prevented from being enabled simultaneously. For example, in the process of charging the battery swapping unit, the insulation detector within the slave high-voltage box of each battery swapping unit detects the insulation impedance to ground of the high-voltage bus in the battery swapping unit. In the case where the battery system is assembled in the vehicle, the insulation detector within the master high-voltage box is enabled, so as to detect the insulation impedance corresponding to the battery system, and the insulation detector within the slave high-voltage box is not enabled by default, thereby helping to improve the accuracy of the detection result output by the insulation detector.

In a possible implementation, in the case where the battery system is assembled in the electric apparatus, the insulation detector in the master high-voltage box is configured to be enabled, and the insulation detector in the slave high-voltage box is configured to be prevented from being enabled; and/or in the case where the battery system is charged in the battery swapping station, the insulation detector in the slave high-voltage box is configured to be enabled.

In the case where the battery system is assembled in the electric apparatus, the insulation detector in the master high-voltage box is enabled. In this case, if the insulation detectors in the slave high-voltage boxes are also enabled, high-voltage coupling will occur, resulting in mutual interference. Since the plurality of battery swapping units are connected in parallel, the resistance decreases after the parallel connection among the plurality of battery swapping units. The insulation impedance corresponding to a certain battery swapping unit is merged into the insulation impedance corresponding to another battery swapping unit, thereby lowering the insulation impedance corresponding to the entire battery system and affecting the detection result output by the insulation detector. In the case where the battery system is charged in the battery swapping station, the insulation detector in the slave high-voltage box is enabled, so as to detect the insulation impedance corresponding to the respective battery swapping unit.

In a possible implementation, the master high-voltage box and/or the slave high-voltage box further includes a high-voltage detection circuit, and the high-voltage detection circuit is configured to detect a voltage of the high-voltage bus and/or a voltage across a relay. In this way, the first battery management unit can determine a risk of the battery system in time based on the voltage information detected by the high-voltage detection circuit, for example, whether relay sticking has occurred.

In a possible implementation, the slave high-voltage box further includes a main positive relay connected to a positive electrode of the slave high-voltage box, and/or a main negative relay connected to a negative electrode of the slave high-voltage box. In the case where the battery system is assembled in the electric apparatus for discharging, the main positive relay and the main negative relay can provide protection for the power output; and in the case where the battery system is charged in the battery swapping station, the main positive relay and the main negative relay can provide protection for the power input.

In a possible implementation, the slave high-voltage box includes at least one high-voltage connector and at least one low-voltage connector, the high-voltage connector includes a main loop connector for connecting the master high-voltage box and a branch connector for connecting the battery on each branch, and the low-voltage connector includes an external low-voltage connector for connecting the master high-voltage box and a low-voltage input/output connector for connecting a cell sampling circuit of the battery on each branch. Through the high-voltage connector and the low-voltage connector in the slave high-voltage box, a high-voltage connection and a low-voltage connection between the slave high-voltage box and the battery and the master high-voltage box can be achieved, thereby realizing effective transmission of high-voltage signals and low-voltage signals.

In a possible implementation, the electrical connector is arranged on an outer frame of the battery swapping unit, the high-voltage interface on the electrical connector is configured to connect to the main loop connector of the slave high-voltage box, and the low-voltage interface on the electrical connector is configured to connect to the external low-voltage connector of the slave high-voltage box. In this embodiment, the electrical connector may be arranged on the outer frame of the battery swapping unit. Specifically, the main loop connector and the external low-voltage connector on the slave high-voltage box may be connected to the high-voltage interface and low-voltage interface of the electrical connector, respectively, so as to facilitate the connection between the slave high-voltage box and the master high-voltage box via the electrical connector.

In a possible implementation, a current sensor is arranged on each branch in the slave high-voltage box, and the current sensor is configured to detect a current on a corresponding branch. Current information corresponding to each branch may be sent to the first battery management unit in real time, such that the first battery management unit performs overcurrent determination and SOC calculation.

In a possible implementation, the master high-voltage box further includes a main positive relay connected to a positive electrode of the master high-voltage box, and/or a main negative relay connected to a negative electrode of the master high-voltage box. The main positive relay and the main negative relay in the master high-voltage box are controlled by the second battery management unit, and are configured to open and close the high-voltage output of the entire battery system to the outside.

In a possible implementation, the master high-voltage box further includes a charging positive relay connected to the positive electrode of the master high-voltage box, and/or a charging negative relay connected to the negative electrode of the master high-voltage box, and the charging positive relay and the charging negative relay are configured to connect to a socket of the electric apparatus, so as to charge the battery system. In this way, in the case where the electric apparatus requires temporary charging, the electric apparatus can be charged via a charging apparatus other than the battery swapping station, such as a charging gun of a charging pile.

In a possible implementation, the master high-voltage box further includes at least one high-voltage connector and at least one low-voltage connector, the high-voltage connector includes a subsystem connector for connecting the slave high-voltage box and a main loop connector for connecting a vehicle control unit, and the low-voltage connector includes a low-voltage connector for communicating with the slave high-voltage box and a low-voltage connector for communicating with the vehicle control unit. Through the high-voltage connector and the low-voltage connector in the master high-voltage box, a high-voltage connection and a low-voltage connection between the master high-voltage box and the battery and the vehicle control unit can be achieved, thereby realizing effective transmission of high-voltage signals and low-voltage signals.

In a possible implementation, the master high-voltage box and/or the slave high-voltage box further includes a manual service disconnect, and a fuse unit is integrated on the manual service disconnect. In this way, the slave high-voltage box can provide overload and short-circuit protection for the corresponding battery swapping unit through the manual service disconnect, and features a plug-in function, which can disconnect the high-voltage connection from the battery swapping unit to the outside during maintenance. The master high-voltage box can provide overload and short-circuit protection for the entire battery system through the manual service disconnect, and features a plug-in function, which can disconnect the high-voltage connection from the entire battery system to the outside during maintenance.

In a fourth aspect, a high-voltage box of a battery system is provided. The high-voltage box is a master high-voltage box of the battery system. The battery system further includes a plurality of battery swapping units connected in parallel. Each battery swapping unit includes a battery and a slave high-voltage box connected to the battery. The master high-voltage box is connected to the slave high-voltage box via a pluggable electrical connector. The slave high-voltage box includes a first battery management unit of the battery, and the master high-voltage box includes a second battery management unit connected to the first battery management units in the plurality of battery swapping units.

According to the present application, the slave high-voltage boxes in the plurality of battery swapping units connected in parallel, and the master high-voltage box are connected via the pluggable electrical connector. Therefore, the plurality of battery swapping units can be disassembled independently, and the plurality of battery swapping units do not need to be bound for use, allowing only a portion of the battery swapping units to be swapped and charged. This supports the mixed use of the battery swapping units, thereby resulting in high battery swapping efficiency and facilitating the construction and operation of the battery swapping station.

In a possible implementation, the electrical connector includes a high-voltage interface and a low-voltage interface, a high-voltage line in the master high-voltage box is connected to a high-voltage line in the slave high-voltage box via the high-voltage interface, and a low-voltage line in the slave main voltage box is connected to a low-voltage line in the slave high-voltage box via the low-voltage interface.

The electrical connector includes the high-voltage interface and the low-voltage interface to enable a high-voltage connection and a low-voltage connection between the slave high-voltage box and the master high-voltage box.

In a possible implementation, the master high-voltage box and/or the slave high-voltage box further includes an insulation detector, the insulation detector is configured to detect insulation impedance to ground of a high-voltage bus, and the insulation detector in the master high-voltage box and the insulation detector in the slave high-voltage box are configured to be prevented from being enabled simultaneously.

In this implementation, the insulation detectors in the master high-voltage box and the slave high-voltage box are configured to be prevented from being enabled simultaneously. For example, in the process of charging the battery swapping unit, the insulation detector within the slave high-voltage box of each battery swapping unit detects the insulation impedance to ground of the high-voltage bus in the battery swapping unit. In the case where the battery system is assembled in the vehicle, the insulation detector within the master high-voltage box is enabled, so as to detect the insulation impedance corresponding to the battery system, and the insulation detector within the slave high-voltage box is not enabled by default, thereby helping to improve the accuracy of the detection result output by the insulation detector.

In a possible implementation, in the case where the battery system is assembled in the electric apparatus, the insulation detector in the master high-voltage box is configured to be enabled, and the insulation detector in the slave high-voltage box is configured to be prevented from being enabled; and/or in the case where the battery system is charged in the battery swapping station, the insulation detector in the slave high-voltage box is configured to be enabled.

In the case where the battery system is assembled in the electric apparatus, the insulation detector in the master high-voltage box is enabled. In this case, if the insulation detectors in the slave high-voltage boxes are also enabled, high-voltage coupling will occur, resulting in mutual interference. Since the plurality of battery swapping units are connected in parallel, the resistance decreases after the parallel connection among the plurality of battery swapping units. The insulation impedance corresponding to a certain battery swapping unit is merged into the insulation impedance corresponding to another battery swapping unit, thereby lowering the insulation impedance corresponding to the entire battery system and affecting the detection result output by the insulation detector. In the case where the battery system is charged in the battery swapping station, the insulation detector in the slave high-voltage box is enabled, so as to detect the insulation impedance corresponding to the respective battery swapping unit.

In a possible implementation, the master high-voltage box and/or the slave high-voltage box further includes a high-voltage detection circuit, and the high-voltage detection circuit is configured to detect a voltage of the high-voltage bus and/or a voltage across a relay. In this way, the first battery management unit can determine a risk of the battery system in time based on the voltage information detected by the high-voltage detection circuit, for example, whether relay sticking has occurred.

In a possible implementation, the electrical connector is arranged on an outer frame of the battery swapping unit, the high-voltage interface on the electrical connector is configured to connect to the main loop connector of the slave high-voltage box, and the low-voltage interface on the electrical connector is configured to connect to the external low-voltage connector of the slave high-voltage box. In this embodiment, the electrical connector may be arranged on the outer frame of the battery swapping unit. Specifically, the main loop connector and the external low-voltage connector on the slave high-voltage box may be connected to the high-voltage interface and low-voltage interface of the electrical connector, respectively, so as to facilitate the connection between the slave high-voltage box and the master high-voltage box via the electrical connector.

In a possible implementation, the master high-voltage box further includes a main positive relay connected to a positive electrode of the master high-voltage box, and/or a main negative relay connected to a negative electrode of the master high-voltage box. The main positive relay and the main negative relay in the master high-voltage box are controlled by the second battery management unit, and are configured to open and close the high-voltage output of the entire battery system to the outside.

In a possible implementation, the master high-voltage box further includes a charging positive relay connected to the positive electrode of the master high-voltage box, and/or a charging negative relay connected to the negative electrode of the master high-voltage box, and the charging positive relay and the charging negative relay are configured to connect to a socket of the electric apparatus, so as to charge the battery system. In this way, in the case where the electric apparatus requires temporary charging, the electric apparatus can be charged via a charging apparatus other than the battery swapping station, such as a charging gun of a charging pile.

In a possible implementation, the master high-voltage box further includes at least one high-voltage connector and at least one low-voltage connector, the high-voltage connector includes a subsystem connector for connecting the slave high-voltage box and a main loop connector for connecting a vehicle control unit, and the low-voltage connector includes a low-voltage connector for communicating with the slave high-voltage box and a low-voltage connector for communicating with the vehicle control unit. Through the high-voltage connector and the low-voltage connector in the master high-voltage box, a high-voltage connection and a low-voltage connection between the master high-voltage box and the battery and the vehicle control unit can be achieved, thereby realizing effective transmission of high-voltage signals and low-voltage signals.

In a possible implementation, the master high-voltage box and/or the slave high-voltage box further includes a manual service disconnect, and a fuse unit is integrated on the manual service disconnect. In this way, the slave high-voltage box can provide overload and short-circuit protection for the corresponding battery swapping unit through the manual service disconnect, and features a plug-in function, which can disconnect the high-voltage connection from the battery swapping unit to the outside during maintenance. The master high-voltage box can provide overload and short-circuit protection for the entire battery system through the manual service disconnect, and features a plug-in function, which can disconnect the high-voltage connection from the entire battery system to the outside during maintenance.

In a fifth aspect, a battery swapping apparatus is provided. The battery swapping apparatus is applied to a battery system. The battery system includes a plurality of battery swapping units connected in parallel. Each battery swapping unit includes a battery and a first battery management unit of the battery, and the battery system further includes a second battery management unit connected to the first battery management units in the plurality of battery swapping units. The battery swapping apparatus includes: a receiving module configured to receive a first power-on signal sent by a vehicle control unit; and a sending module configured to send, in response to the first power-on signal, a second power-on signal to the first battery management unit, where the second power-on signal is used to instruct the first battery management unit to control a corresponding battery swapping unit to perform high-voltage power-on.

In a possible implementation, the battery swapping apparatus further includes a processing module configured to determine the number of the plurality of battery swapping units. The sending module is specifically configured to send, in the case where the number of the plurality of battery swapping units is equal to a preset number, the second power-on signal to the first battery management unit.

In a possible implementation, the processing module is specifically configured to: control the sending module to send an encoding signal to the first battery management unit of the first battery swapping unit among the plurality of battery swapping units, where the encoding signal is used to be sequentially transmitted among the first battery management units in the plurality of battery swapping units, so as to sequentially encode the plurality of battery swapping units; control the receiving module to receive an encoding result sent by the first battery management unit of the last battery swapping unit among the plurality of battery swapping units; and determine, based on the encoding result, the number of the plurality of battery swapping units.

In a possible implementation, the processing module is further configured to determine at least one battery swapping unit to be powered on among the plurality of battery swapping units; and the sending module is specifically configured to send the second power-on signal to the first battery management unit in the at least one battery swapping unit.

In a possible implementation, the processing module is specifically configured to determine, based on voltages of the plurality of battery swapping units, at least one battery swapping unit to be powered on among the plurality of battery swapping units.

In a possible implementation, the processing module is specifically configured to: in the case where the voltage difference between a highest-voltage battery swapping unit and a lowest-voltage battery swapping unit among the plurality of battery swapping units is greater than or equal to the voltage threshold, determine that the at least one battery swapping unit includes a battery swapping unit having a voltage difference from the highest-voltage battery swapping unit less than the voltage threshold.

In a possible implementation, the processing module is specifically configured to: in the case where the voltage difference between the highest-voltage battery swapping unit and the lowest-voltage battery swapping unit among the plurality of battery swapping units is less than or equal to the voltage threshold, determine that the at least one battery swapping unit includes the plurality of battery swapping units.

In a possible implementation, the battery swapping unit further includes a slave high-voltage box connected to the battery, and the slave high-voltage box includes a first relay unit, where the second power-on signal is specifically used to instruct the first battery management unit to control a corresponding first relay unit to close.

In a possible implementation, the battery system further includes a master high-voltage box, the slave high-voltage box is connected to the master high-voltage box via a pluggable electrical connector, the master high-voltage box includes a second relay unit, and the processing module is further configured to control the second relay unit to close after the first relay unit in the at least one battery swapping unit is closed.

In a possible implementation, the sending module is further configured to send a power-on completion signal to the vehicle control unit after the second relay unit is closed.

In a possible implementation, the sending module is further configured to send information on an allowable power of the battery system, where the allowable power of the battery system is a sum of the allowable powers of the plurality of battery swapping units.

In a possible implementation, the receiving module is further configured to receive a wake-up signal; and the processing module is further configured to perform, based on the wake-up signal, low-voltage power-on on the second battery management unit.

In a sixth aspect, a battery swapping apparatus is provided. The battery swapping apparatus is applied to a battery system. The battery system includes a plurality of battery swapping units connected in parallel. Each battery swapping unit includes a battery and a first battery management unit of the battery, and the battery system further includes a second battery management unit connected to the first battery management units in the plurality of battery swapping units. The battery swapping apparatus includes: a processing module configured to determine whether the battery system meets a high-voltage power-on condition; and a sending module configured to send, in the case where the high-voltage power-on condition is met, a first power-on signal to the second battery management unit, where the first power-on signal is used to instruct the second battery management unit to control the battery system to perform high-voltage power-on.

In a possible implementation, the high-voltage power-on condition includes at least one of the following: relays in the battery system are all in an off state; and the high-voltage electric device connected to the battery system is not enabled.

In a possible implementation, the battery swapping apparatus further includes a receiving module. The receiving module is configured to receive a power-on completion signal sent by the second battery management unit, where the power-on completion signal is used to indicate that the battery system has completed high-voltage power-on; and the processing module is further configured to control, based on the power-on completion signal, a relay in a main loop between the battery system and a high-voltage electric device to close.

In a possible implementation, the battery swapping apparatus further includes a receiving module. The receiving module is configured to receive a wake-up signal; and the processing module is further configured to perform, based on the wake-up signal, low-voltage power-on on the vehicle control unit.

In a seventh aspect, a battery swapping device is provided. The battery swapping device includes a processor and a memory. The memory is configured to store a computer program, and the processor is configured to call and run the computer program stored in the memory, so as to perform the power-on method according to the first aspect or any one of the possible implementations of the first aspect, or perform the power-on method according to the second aspect or any one of the possible implementations of the second aspect.

In an eighth aspect, a chip is provided. The chip includes a processor. The processor is configured to call and run a computer program from a memory, such that a device installed with the chip performs the power-on method according to the first aspect or any one of the possible implementations of the first aspect, or performs the power-on method according to the second aspect or any one of the possible implementations of the second aspect.

In a ninth aspect, a computer-readable storage medium is provided. The computer-readable storage medium is configured to store a computer program. The computer program causes a computer to perform the power-on method according to the first aspect or any one of the possible implementations of the first aspect, or perform the power-on method according to the second aspect or any one of the possible implementations of the second aspect.

In a tenth aspect, an electric apparatus is provided. The electric apparatus includes the battery system according to the third aspect or any one of the possible implementations of the third aspect, and a high-voltage electric device connected to the battery system. The battery system is configured to supply power to the high-voltage electric device.

### BRIEF DESCRIPTION OF THE DRAWINGS

To more clearly illustrate the technical solutions according to embodiments of the present application, the drawings required for illustrating the embodiments of the present application are briefly described below. Apparently, the drawings in the following description illustrate merely some embodiments of the present application, and those of ordinary skill in the art may still derive other drawings from these drawings without creative efforts.

To more clearly illustrate the technical solutions according to embodiments of the present application, the drawings required for illustrating the embodiments of the present application are briefly described below. Apparently, the drawings in the following description illustrate merely some embodiments of the present application, and those of ordinary skill in the art may still derive other drawings from these drawings without creative efforts.
FIG. 1 is a schematic diagram of a battery system according to an embodiment of the present application;
FIG. 2 is a possible specific architecture of a battery system according to an embodiment of the present application;
FIG. 3 is a schematic diagram of single-pack battery swapping according to an embodiment of the present application;
FIG. 4 is a schematic diagram of communication between a second battery management unit and a first battery management unit according to an embodiment of the present application;
FIG. 5 is a diagram of process interaction of a power-on method for a battery system according to an embodiment of the present application;
FIG. 6 is a schematic diagram of encoding of a plurality of battery swapping units in a battery system;
FIG. 7 is a diagram of process interaction of a power-on method for a battery system according to another embodiment of the present application;
FIG. 8 is a flowchart of a possible specific implementation of the power-on method shown in FIGs. 5 and 7; and
FIG. 9 is a schematic block diagram of a battery swapping apparatus according to an embodiment of the present application.

The drawings are not drawn to scale.

### DETAILED DESCRIPTION

Implementations of the present application will be described in further detail with reference to the drawings and embodiments. The following detailed description of the embodiments and the drawings are used for the exemplary illustration of the principles of the present application, but are not intended to limit the scope of the present application. That is, the present application is not limited to the described embodiments.

In the description of the present application, it should be noted that, unless otherwise specified, "a plurality" means two or more; the orientations or positional relationships indicated by the terms "upper", "lower", "left", "right", "inner", "outer", and the like are merely for the convenience of describing the present application and simplifying the description, rather than indicating or implying that the apparatus or element referred to must have a specific orientation or be configured and operated in the specific orientation, and thus should not be construed as limitations to the present application. Furthermore, the terms "first", "second", "third", and the like are used for descriptive purposes only and should not be construed as indicating or implying relative importance.

In the description of the present application, it should further be noted that unless otherwise explicitly specified or defined, the terms "install", "interconnect", and "connect" shall be construed broadly and may be, for example, fixed connection, detachable connection, or integral connection, or direct connection or indirect connection via an intermediate. For those of ordinary skill in the art, the specific meaning of the above terms in the present application may be interpreted according to the specific condition.

In the present application, the term "and/or" is merely a way to describe the association relationship between associated objects and indicates that there are three possible relationships. For example, A and/or B may indicate that: only A is present, both A and B are present, and only B is present. In addition, the character "/" in the present application generally indicates an "or" relationship between the associated objects before and after the "/".

Unless otherwise defined, all technical and scientific terms used in the present application have the same meaning as commonly understood by those skilled in the art to which the present application belongs. The terms used in the specification of the present application are only used to describe specific embodiments and are not intended to limit the present application. The terms "include", "comprise", "have", and any variants thereof in the specification and claims of the present application and the above description of the drawings are intended to cover a non-exclusive inclusion. The terms "first", "second", and the like in the specification and claims of the present application and the above drawings are used to distinguish different objects and are not intended to describe a specific order or priority.

Reference in the present application to "embodiment" means that a particular feature, structure, or characteristic described in connection with the embodiment can be included in at least one embodiment of the present application. The references of the word in the context of the specification do not necessarily refer to the same embodiment, nor to separate or alternative embodiments exclusive of other embodiments. It will be explicitly and implicitly understood by those skilled in the art that the described embodiments of the present application can be combined with other embodiments.

With the development of new energy technologies, the application fields of batteries have become increasingly widespread, such as providing driving power for an electric apparatus or supplying electric energy to an electric apparatus. For example, the battery may be used as a power source to provide driving power for the vehicle. In the case where the electric energy of the battery in the vehicle is insufficient to support the vehicle to continue traveling, the vehicle may be charged by using a charging device such as a charging pile or a battery charger, that is, charging the battery in the vehicle, thereby achieving charge-discharge cycling of the battery. However, charging the battery takes a relatively long time, which limits the use of the driving range of the vehicle.

To improve the driving range utilization rate of the vehicle, battery swapping technologies have emerged. The battery swapping technology adopts a "vehicle-battery separation" mode, which can provide a battery replacement service for a vehicle via a battery swapping station; that is, the battery can be rapidly removed from or installed on the vehicle. The battery removed from the vehicle can be put into a battery swapping cabinet of the battery swapping station for charging, so as to prepare for battery swapping of a vehicle subsequently entering the battery swapping station. The advantages of the battery swapping technology are that battery swapping can be completed in a few minutes, and consumers can rent or purchase batteries to reduce initial vehicle purchasing costs. Therefore, the battery swapping technology has been widely favored by consumers.

The battery in the embodiments of the present application may be, for example, a lithium-ion battery, a lithium metal battery, a lead-acid battery, a nickel-separator battery, a nickel-hydrogen battery, a lithium-sulfur battery, a lithium-air battery, or a sodium-ion battery, which is not limited herein. In terms of scale, the battery may be a battery cell, a battery module, or a battery pack, which is not limited herein.

For a passenger vehicle, a battery swapping cabinet is arranged in the battery swapping station. The battery swapping cabinet may be provided with a plurality of charging compartments, and a battery pack for battery swapping may be placed in the charging compartment of the battery swapping cabinet. A charging unit is arranged in the charging compartment, and the charging unit can charge the battery in the charging compartment. For example, the charging unit may include a component, an apparatus, or a device with a charging function, such as an alternating current/direct current module, i.e., an AC/DC module, which is not limited herein. The charging unit may be arranged in a one-to-one correspondence with the charging compartment, or a plurality of charging compartments may share one charging unit, which is not limited herein.

For a heavy truck, the battery is arranged in a battery case, and a plurality of batteries may be arranged in one battery case. When battery swapping is performed at the battery swapping station, it is actually the battery case that has been replaced. That is, the battery case on the vehicle is replaced with the battery case in the battery swapping station. The battery case in the battery swapping station can charge the battery in the battery case via the charging apparatus arranged in the battery swapping station.

Generally, a heavy truck adopts a rear-mounted battery swapping; that is, the battery case is arranged behind the seat. Since batteries are arranged in a centralized manner and the entire battery system is integrated into a single battery swapping pack, a conventional two-tier architecture may be adopted, i.e., an architecture formed by a cell sampling circuit (CSC) and a battery management unit (BMU). The CSC is configured to collect information such as the voltage and the temperature of a battery cell, and the BMU is configured to manage the battery based on the information.

However, for a heavy truck with a chassis-based battery arrangement, since some batteries are arranged in a dispersed manner, a solution of a plurality of battery swapping packs is generally adopted; that is, the plurality of battery swapping packs are separately arranged at different positions of the vehicle chassis. If the conventional two-tier architecture is still adopted, the following problems may exist.

Firstly, the BMU needs to track the battery case to calculate information such as the state of charge (SOC), the state of health (SOH), and other states of X (SOX) based on historical battery data, and perform a tracing operation. Therefore, the BMU needs to be arranged in one of the battery swapping packs, and high-voltage and low-voltage short-connections need to be performed among the plurality of battery swapping packs, such that the plurality of battery swapping packs always need to be bound for use, resulting in low battery swapping efficiency. In addition, the construction and operation costs of the battery swapping station are increased, and the applicability of the battery swapping scenario is poor.

Secondly, due to the use of the plurality of battery swapping packs, the number of battery sampling circuits increases. However, the number of sampling nodes that a general battery management unit can support is limited. As a result, a single battery management unit cannot meet the requirements.

Therefore, the embodiments of the present application provide a multi-pack battery system and a power-on method for the same, which aim to solve the problems of low battery swapping efficiency, high construction and operation costs of the battery swapping station, and poor applicability of the battery swapping scenario by improving the electrical architecture of the battery system, and effectively achieve high-voltage power-on of the battery system through a reasonable power-on process.

It should be understood that the electric apparatus according to the embodiments of the present application may be a vehicle, or may be an apparatus that uses a battery to provide driving power or supply electric energy, such as a robot, a ship, or an aircraft, in the future. The embodiments of the present application are described by taking a vehicle as an example.

Hereinafter, the battery case in the battery swapping scenario is referred to as a battery swapping unit, which may be, for example, the battery swapping pack described above. In the application scenario of a heavy truck, the battery swapping unit may also be referred to as a battery swapping cabinet.

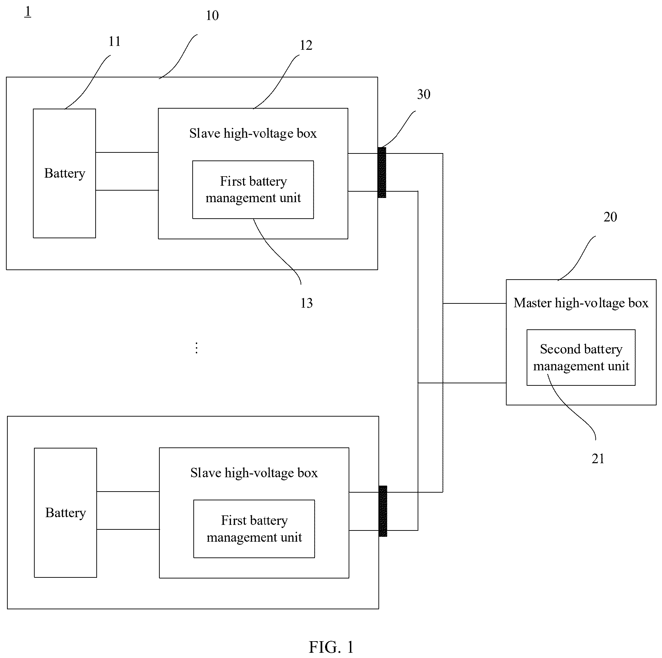

FIG. 1 is a schematic diagram of a battery system according to an embodiment of the present application. As shown in FIG. 1, the battery system 1 includes a plurality of battery swapping units 10. The plurality of battery swapping units 10 are connected in parallel. Each battery swapping unit 10 includes a battery 11 and a slave high-voltage box 12 connected to the battery, and the slave high-voltage box 12 includes a first battery management unit 13 of the battery 11. The battery system 1 further includes a master high-voltage box 20. The slave high-voltage box 12 is connected to the master high-voltage box 20 via a pluggable electrical connector 30, and the master high-voltage box 20 includes a second battery management unit 21 connected to the first battery management units 13 in the plurality of battery swapping units 10.

Generally, the high-voltage box is also referred to as a high-voltage power distribution box or a power distribution box. It can be understood that, although referred to as a high-voltage box, the high-voltage box not only includes a high-voltage loop and a corresponding component, but may also include a low-voltage loop and a corresponding component.

The battery system 1 adopts a three-tier architecture formed by a CSC, a first battery management unit, and a second battery management unit. The first battery management unit and the second battery management unit may be collectively referred to as the battery management system. The battery 11 may be a battery pack, and is generally formed by connecting a plurality of battery cells in series, in parallel, or in series-parallel, where the series-parallel connection refers to a combination of parallel connection and series connection. A cell sampling circuit (CSC) is arranged on each battery cell, and is configured to collect information such as the voltage and the temperature of a corresponding battery cell. The first battery management unit 13 provides full battery management system (BMS) functions, including calculation of information such as the SOC, the SOH, ..., and the SOX of the battery 11, fault diagnosis, battery balancing, and monitoring and protection. The second battery management unit 21 is responsible for collecting and arbitrating information about all battery swapping units 10, and interacting with an external device. The external device includes, but is not limited to, a vehicle control unit (VCU), or a charging apparatus for charging the battery 11, such as a charging pile or a battery charger.

The first battery management unit according to the embodiments of the present application may be, for example, a sub-battery management unit (SBMU), and the second battery management unit may be, for example, a master battery management unit (MBMU). Hereinafter, the technical solutions of the present application are described by taking the first battery management unit being an SBMU and the second battery management unit being an MBMU as an example.

The electrical connector 30 is a dedicated connector for enabling rapid electrical connection and disconnection between the battery and the vehicle, and between the battery and the battery swapping cabinet in the battery swapping station, and is composed of, for example, a plug and a socket. Since the electrical connector 30 is mainly applied in a battery swapping scenario, it is also referred to as a "battery swapping connector" or a "quick-swap connector".

In some embodiments, the electrical connector 30 includes a high-voltage interface and a low-voltage interface. A high-voltage line in the slave high-voltage box 12 is connected to a high-voltage line in the master high-voltage box 20 via the high-voltage interface, and a low-voltage line in the slave high-voltage box 12 is connected to a low-voltage line in the master high-voltage box 20 via the low-voltage interface, thereby achieving a high-voltage connection and a low-voltage connection between the slave high-voltage box 12 and the master high-voltage box 20. The high-voltage interface includes, for example, a positive high-voltage interface and a negative high-voltage interface. The positive high-voltage interface is configured to connect to a positive electrode of the battery 11, and the negative high-voltage interface is configured to connect to a negative electrode of the battery 11.

In the embodiments of the present application, a battery 11 and a slave high-voltage box 12 connected to the battery are arranged in each battery swapping unit 10, a corresponding SBMU 13 is provided in the slave high-voltage box 12, the battery system 1 is further provided with a master high-voltage box 20 connected to the slave high-voltage box 12 of each battery swapping unit 10, and the master high-voltage box 20 is provided with an MBMU 21 connected to the SBMU 13 of each slave high-voltage box 12. Since a three-tier architecture formed by a CSC, an SBMU, and an MBMU is adopted, during the battery swapping process, the battery swapping units 10 can be disconnected via the pluggable electrical connectors 30 between the slave high-voltage boxes 12 and the master high-voltage box 20 of the battery swapping units. Therefore, the plurality of battery swapping units 10 can be disassembled independently, and the plurality of battery swapping units 10 do not need to be bound for use, allowing only a portion of the battery swapping units 10 to be swapped and charged. This supports the mixed use of the battery swapping units 10, thereby resulting in high battery swapping efficiency, facilitating the construction and operation of the battery swapping station, and expanding the battery swapping scenarios applicable to the battery system 1.

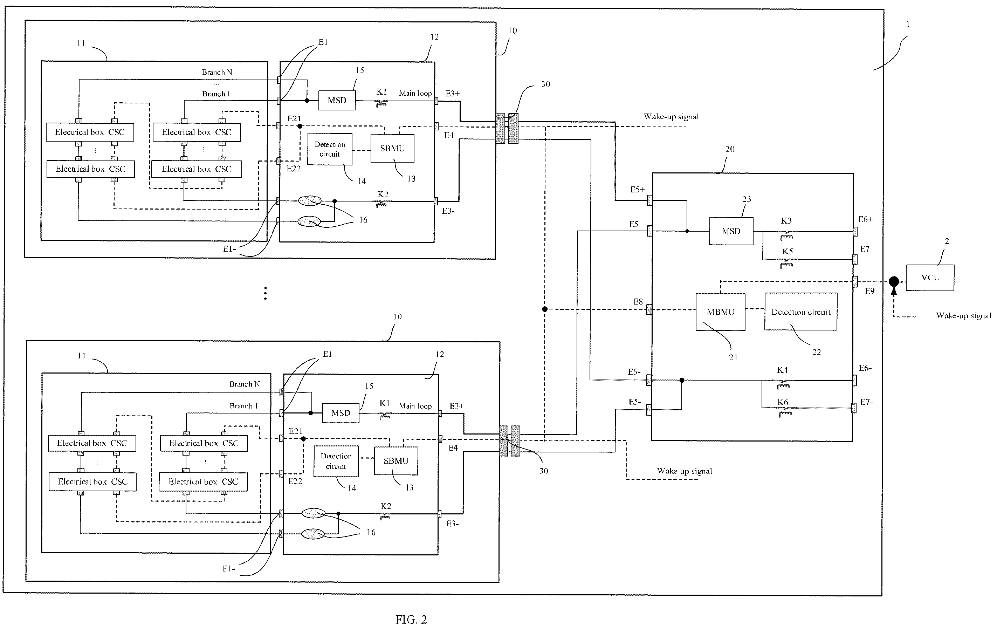

As an example, FIG. 2 shows a possible specific architecture of a battery system 1 according to an embodiment of the present application. As shown in FIG. 2, the battery system 1 includes a plurality of battery swapping units 10, i.e., a plurality of battery swapping packs or a plurality of battery swapping cabinets, and the battery system 1 is provided with a master high-voltage box 20. Each battery swapping unit 10 includes a battery 11, and is provided with a corresponding slave high-voltage box 12. The battery swapping unit 10 is connected to the master high-voltage box 20 via a pluggable electrical connector 30.

The battery 11 in each battery swapping unit 10 is composed of a plurality of battery cells. For example, as shown in FIG. 2, the plurality of battery cells are first connected in series and then connected in parallel to form an electrical box, and a plurality of electrical boxes are connected in series or in parallel to form the battery 11. Optionally, a CSC may be arranged on each battery cell to collect information such as the voltage and the temperature of the battery cell. The battery 11 is connected to the slave high-voltage box 12, and an SBMU 13 is integrated in the slave high-voltage box 12 to be responsible for the management of the corresponding battery swapping unit 10 and to upload related data to the MBMU 21 in the master high-voltage box 20. The MBMU 21 is responsible for the operation and management of the entire battery system 1 and interacts with an external device, such as a VCU and a charging apparatus.

Shown in FIG. 2 is the case where the battery system 1 is assembled in an electric apparatus such as a vehicle. The plurality of battery swapping units 10 share the same voltage platform; and the plurality of battery swapping units 10 are parallel systems, and are connected in parallel in the master high-voltage box 20 for energy output.

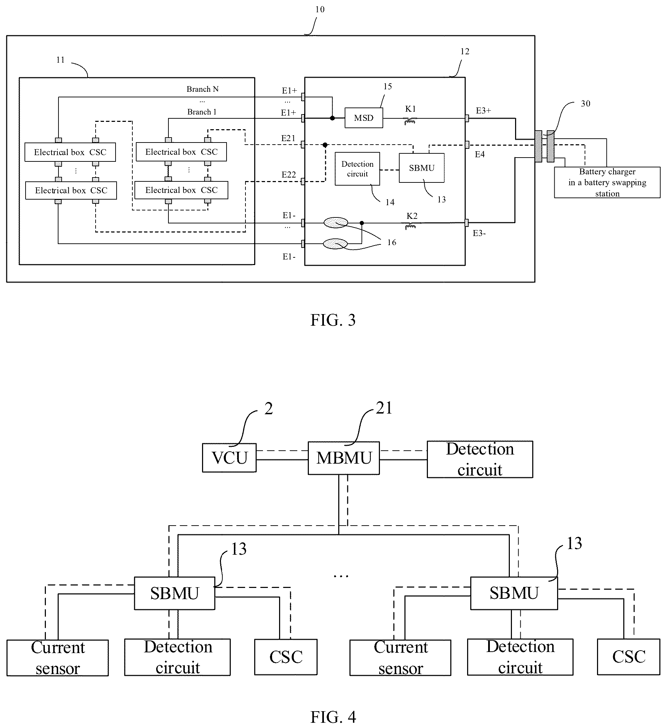

The plurality of battery swapping units 10 do not need to be bound for charging, and each battery swapping unit 10 may be charged separately, or the plurality of battery swapping units 10 may be charged together as a system. For example, as shown in a schematic diagram of single-pack battery charging in FIG. 3, each battery swapping unit 10 may be connected to a battery swapping machine of a battery swapping station via an electrical connector 30 for charging.

In some embodiments, the master high-voltage box 20 and/or the slave high-voltage box 12 further includes a detection circuit, which may also be referred to as a high voltage box (HVB). The detection circuit may be connected to the SBMU, so as to transmit a detection result to the SBMU via a low-voltage line between the detection circuit and the SBMU. The detection circuit includes, for example, an insulation detector, and the insulation detector is configured to detect the insulation impedance to ground of the high-voltage bus. Since a connection between the high-voltage positive electrode or the high-voltage negative electrode and ground may pose a risk, the insulation impedance between the high-voltage bus and the ground is generally required to be maintained at a certain level. The insulation detector can detect the insulation impedance. When the insulation impedance does not meet a requirement, detection or maintenance on the battery system 1 is facilitated, thereby reducing the risk of the battery system 1.

The insulation detector in the master high-voltage box 20 and the insulation detector in the slave high-voltage box 12 are configured to be prevented from being enabled simultaneously; that is, when the insulation detector in the master high-voltage box 20 is enabled, the insulation detector in the slave high-voltage box 12 is prevented from being enabled; when the insulation detector in the slave high-voltage box 12 is enabled, the insulation detector in the master high-voltage box 20 may not be enabled.

For example, in the case where the battery system 1 is assembled in the electric apparatus, the insulation detector in the master high-voltage box 20 is configured to be enabled, and the insulation detector in the slave high-voltage box 12 is configured to be prevented from being enabled; and/or in the case where the battery system 1 is charged in the battery swapping station, the insulation detector in the slave high-voltage box 12 is configured to be enabled.

Taking FIGs. 2 and 3 as an example, the slave high-voltage box 12 of the battery swapping unit 10 includes a first detection circuit 14, and the master high-voltage box 20 includes a second detection circuit 22. Both the first detection circuit 14 and the second detection circuit 22 are provided with an insulation detector, and the insulation detector in the first detection circuit 14 and the insulation detector in the second detection circuit 22 are configured to be prevented from being enabled simultaneously. In the process of charging the battery swapping unit 10 in the battery swapping station, the insulation detector in the first detection circuit 14 within the slave high-voltage box 12 of each battery swapping unit 10 is enabled, so as to detect the insulation impedance to ground of the positive electrode and the negative electrode of the high-voltage bus in the battery swapping unit 10. In the case where the battery system 1 is assembled in the vehicle, the insulation detector in the second detection circuit 22 within the master high-voltage box 20 is enabled, so as to detect the insulation impedance to ground of the positive electrode and the negative electrode of the high-voltage bus in the master high-voltage box 20, and the insulation detector in the first detection circuit 14 within the slave high-voltage box 12 is not enabled by default, thereby helping to improve the accuracy of the detection result output by the insulation detector in the second detection circuit 22.

Specifically, in the case where the battery system 1 is assembled in the vehicle, the insulation detector in the master high-voltage box 20 is enabled. In this case, if the insulation detectors in the slave high-voltage boxes 12 are also enabled, high-voltage coupling will occur, resulting in mutual interference. Since the plurality of battery swapping units 10 are connected in parallel, the resistance decreases after the parallel connection among the plurality of battery swapping units 10. The insulation impedance to ground of the high-voltage bus of a certain battery swapping unit 10 is merged into the insulation impedance to ground of the high-voltage bus of another battery swapping unit 10, thereby lowering the insulation impedance corresponding to the entire battery system 1, and further affecting the detection result output by the insulation detector. In the case where the battery system 1 is charged in the battery swapping station, the insulation detector in the slave high-voltage box 12 is required to be enabled, so as to detect the insulation impedance to ground of the high-voltage bus of the corresponding battery swapping unit 10 thereof.

The detection circuit in the master high-voltage box 20 and/or in the slave high-voltage box 12 further includes, for example, a high-voltage detection circuit for detecting the voltage of the high-voltage bus, and/or detecting the voltage across a relay, such as a main positive relay and/or a main negative relay. In this way, the SBMU 13 can determine a risk of the battery system in time based on the voltage information detected by the high-voltage detection circuit, for example, whether relay sticking has occurred.

In some embodiments, the master high-voltage box 20 and/or the slave high-voltage box 12 may further include other components, such as a relay unit, a manual service disconnect (MSD), a current sensor, a high-voltage sampling board, and various connectors for internal or external connection. The relay unit includes at least a main positive relay and/or a main negative relay located in a main loop of the battery system 1.

The slave high-voltage box 12 includes a main positive relay connected to a positive electrode of the slave high-voltage box 12, and/or a main negative relay connected to a negative electrode of the slave high-voltage box 12. In the case where the battery system 1 is assembled in the electric apparatus for discharging, the main positive relay and the main negative relay in the slave high-voltage box 12 can provide protection for the power output; and in the case where the battery system 1 is charged in the battery swapping station, the main positive relay and the main negative relay in the slave high-voltage box 12 can provide protection for the power input.

The master high-voltage box 20 includes a main positive relay connected to a positive electrode of the master high-voltage box 20, and/or a main negative relay connected to a negative electrode of the master high-voltage box 20. The main positive relay and the main negative relay in the master high-voltage box 20 are controlled by the MBMU 21, and are configured to open and close the high-voltage output of the entire battery system 1 to the outside.

For example, as shown in FIGs. 2 and 3, the slave high-voltage box 12 is provided with a first relay unit, including a main positive relay K1 and a main negative relay K2. The main positive relay K1 and the main negative relay K2 are connected in series in the main loop of the battery 11. One end of the main positive relay K1 is configured to connect to the positive electrode of the battery 11, and the other end is configured to connect to the electrical connector 30. One end of the main negative relay K2 is configured to connect to the negative electrode of the battery 11, and the other end is configured to connect to the electrical connector 30. The SBMU 13 controls the main positive relay K1 and the main negative relay K2 to close and open. The master high-voltage box 20 is provided with a second relay unit, including a main positive relay K3 and a main negative relay K4. The main positive relay K3 and the main negative relay K4 are connected in series in the main loop of the battery 11, and the MBMU 21 controls the main positive relay K3 and the main negative relay K4 to close and open.

Optionally, the first relay unit and the second relay unit may also include other relays. For example, the master high-voltage box 20 may further include a charging positive relay connected to the positive electrode of the master high-voltage box 20, and/or a charging negative relay connected to the negative electrode of the master high-voltage box 20. The charging positive relay and the charging negative relay are configured to connect to a socket of an electric apparatus to charge the battery system 1.

As an example, as shown in FIG. 2, the master high-voltage box 20 includes a charging positive relay K5 and a charging negative relay K6, and the master high-voltage box 20 can be connected to a charging socket, such as an on-board charging socket, in the electric apparatus via the charging positive relay K5 and the charging negative relay K6. In this way, in the case where the electric apparatus, such as a vehicle, requires temporary charging, the vehicle can be charged via a charging apparatus other than the battery swapping station, such as a charging gun of a charging pile.

It can be understood that the positive electrodes of the master high-voltage box 20 and the slave high-voltage box 12 refer to interfaces for connecting the positive electrodes of the batteries 11, and the negative electrodes of the master high-voltage box 20 and the slave high-voltage box 12 refer to interfaces for connecting the negative electrodes of the batteries 11.

For another example, as shown in FIGs. 2 and 3, the slave high-voltage box 12 may further be provided with an MSD 15, and the master high-voltage box 20 may further be provided with an MSD 23. The MSD 15 and the MSD 23 are both connected in series on the main loop of the battery 11, and are connected to one side of the positive electrode of the battery 11, and a fuse unit may be, for example, integrated on the MSD 15 and/or the MSD 23. In this way, in a high-voltage environment, to ensure and maintain personnel safety or handle emergency situations, the high-voltage circuit can be rapidly disconnected, such that maintenance and other operations are performed in a safe state. In addition, the MSD 15 and the MSD 23 can not only serve as maintenance protection switches, but also provide short-circuit protection.

Specifically, the slave high-voltage box 12 can provide overload and short-circuit protection for the corresponding battery swapping unit 10 through the MSD 15, and features a plug-in function, which can disconnect the high voltage of the battery swapping unit 10 to the outside during maintenance; and the master high-voltage box 20 can provide overload and short-circuit protection for the entire battery system 1 through the MSD 23, and features a plug-in function, which can disconnect the high voltage of the entire battery system 1 to the outside during maintenance.

For another example, as shown in FIGs. 2 and 3, the slave high-voltage box 12 may further be provided with several current sensors 16. For example, N current sensors 16 are respectively provided in branches 1 to N connected in parallel, where each branch is provided with at least one electrical box connected in series, and the current sensor 16 is configured to detect a current on the branch where the current sensor is located. The current information corresponding to each branch can be sent to the SBMU 13 in real time, thereby facilitating the determination of overcurrent and the calculation of the state of charge (SOC) of the SBMU 13.

As shown in FIGs. 2 and 3, in addition to a high-voltage line, the battery system 1 is further provided with a low-voltage line. The high-voltage line is configured to provide a high-voltage power supply for the high-voltage electric device in the vehicle, and the low-voltage line is configured to provide a low-voltage power supply for low-voltage electric modules, such as the SBMU 13, the MBMU 21, and the VCU 2, and is configured to transmit a low-voltage signal, so as to enable internal and external communication. The solid line and dashed line shown in FIG. 2 represent the high-voltage line and the low-voltage line, respectively. The high-voltage line in the battery swapping unit 10 is connected to the high-voltage line in the master high-voltage box 20 via a high-voltage interface of the electrical connector 30, and the low-voltage line in the battery swapping unit 10 is connected to the low-voltage line in the master high-voltage box 20 via a low-voltage interface of the electrical connector 30.

The master high-voltage box 20 and the slave high-voltage box 12 are further provided with various connectors, which are also referred to as interfaces. Hereinafter, the connectors on the master high-voltage box 20 and the slave high-voltage box 12 are specifically described with reference to FIGs. 2 and 3.

In some embodiments, the slave high-voltage box 12 includes at least one high-voltage connector and at least one low-voltage connector. For example, as shown in FIGs. 2 and 3, the high-voltage connector includes a main loop connector E3 for connecting the master high-voltage box 20 and a branch connector E1 for connecting the battery on each branch, where the main loop connector E3 includes a main loop positive connector E3+ and a main loop negative connector E3-, and the branch connector E1 includes a branch positive connector E1+ and a branch negative connector E1-; and the low-voltage connector includes an external low-voltage connector E4 for connecting the master high-voltage box 20 and a low-voltage input/output connector for connecting the CSC of the battery on each branch, where the low-voltage input/output connector includes a low-voltage output connector E21 and a low-voltage input connector E22. Through the high-voltage connector and the low-voltage connector in the slave high-voltage box 12, a high-voltage connection and a low-voltage connection between the slave high-voltage box 12 and the battery and the master high-voltage box 20 are achieved, thereby realizing effective transmission of high-voltage signals and low-voltage signals.

In some embodiments, as shown in FIGs. 2 and 3, the electrical connector 30 is arranged on an outer frame of the battery swapping unit 10, the high-voltage interface on the electrical connector 30 is configured to connect to the main loop connector E3 of the slave high-voltage box 12, and the low-voltage interface on the electrical connector is configured to connect to the external low-voltage connector E4 of the slave high-voltage box 12.

That is, the electrical connector 30 may be integrated on the outer frame of the battery swapping unit 10. Specifically, the main loop connector E3 and the external low-voltage connector E4 on the slave high-voltage box 12 may be connected to the high-voltage and low-voltage interfaces of the electrical connector 30, respectively, so as to facilitate the connection between the slave high-voltage box 12 and the master high-voltage box 20 via the electrical connector 30.

In some embodiments, the master high-voltage box 20 further includes at least one high-voltage connector and at least one low-voltage connector. For example, as shown in FIG. 3, the high-voltage connector includes a subsystem connector E5 for connecting the slave high-voltage box 12 and a main loop connector E6 for connecting the VCU, where the subsystem connector E5 includes a subsystem positive connector E5+ and a subsystem negative connector E5-, and the main loop connector E6 includes a main loop positive connector E6+ and a main loop negative connector E6-; and the low-voltage connector includes a low-voltage connector E8 for communicating with the slave high-voltage box 12 and a low-voltage connector E9 for communicating with the VCU 2. Through the high-voltage connector and the low-voltage connector in the master high-voltage box 20, a high-voltage connection and a low-voltage connection between the master high-voltage box 20 and the battery and the VCU 2 can be achieved, thereby realizing effective transmission of high-voltage signals and low-voltage signals.

FIG. 4 shows that the communication between the MBMU 21 and the SBMUs 13 in the plurality of battery swapping units 10, the communication between the MBMU 21 and the detection circuit in the master high-voltage box 20, and the communication between the SBMU 13 and the detection circuit, the CSC, and the current sensor in the corresponding slave high-voltage box 12 can all be performed based on a certain communication line, for example, via a controller area network (CAN) bus, to achieve data transmission. The solid line and the dashed line shown in FIG. 4 represent a high-speed CAN bus and a low-speed CAN bus, respectively.

The embodiments of the present application further provide a power-on method for a battery system 1, which can effectively achieve high-voltage power-on of the above battery system 1. The battery system 1 includes a plurality of battery swapping units 10 connected in parallel. Each battery swapping unit 10 includes a battery 11 and an SBMU 13 of the battery; and the battery system 1 further includes an MBMU 21 connected to the SBMUs 13 in the plurality of battery swapping units 10.

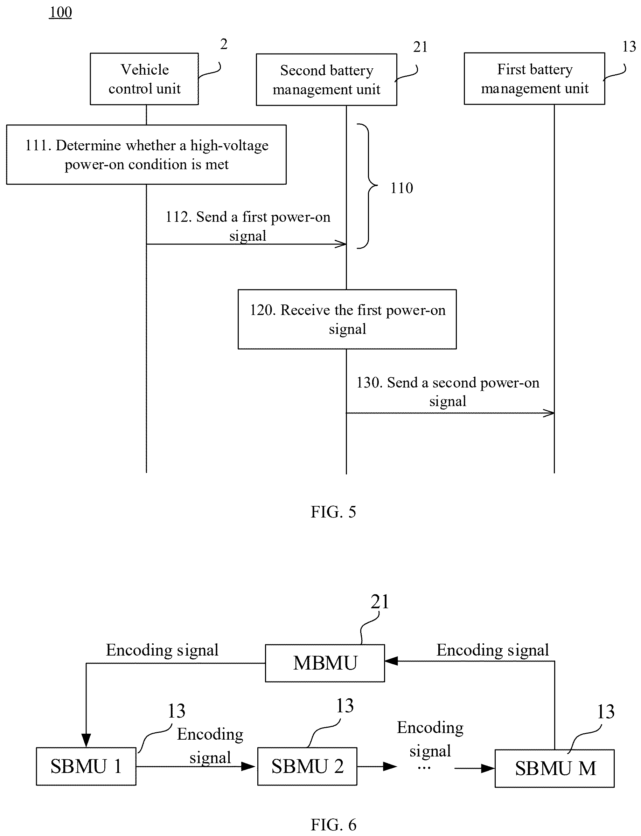

FIG. 5 is a diagram of process interaction of a power-on method 100 according to an embodiment of the present application. The power-on method 100 may be performed by a first battery management unit 13, a second battery management unit 21, a vehicle control unit 2, and the like. In FIG. 5, the case where the first battery management unit 13 is an SBMU 13 and the second battery management unit 21 is an MBMU 21 is taken as an example. As shown in FIG. 5, the power-on method 100 includes some or all of the following steps.

In step 110, the VCU 2 sends a first power-on signal to the MBMU 21.

The first power-on signal is used to instruct the MBMU 21 to control the battery system 1 to perform high-voltage power-on.

The high-voltage power-on is also referred to as high voltage activation; that is, the high-voltage line in the battery system 1 is enabled to be connected.

In step 120, the MBMU 21 receives the first power-on signal sent by the VCU 2.

In step 130, the MBMU 21 sends, in response to the first power-on signal, a second power-on signal to the SBMU 13.

The second power-on signal is configured to instruct the SBMU 13 to control the corresponding battery swapping unit 10 to perform high-voltage power-on.

In the embodiments of the present application, when the battery system 1 is subject to high-voltage power-on, the VCU 2 sends a first power-on signal to the MBMU 21, the MBMU 21 receives the first power-on signal sent by the VCU 2, and sends, in response to the first power-on signal, a second power-on signal to the SBMU 13, and the SBMU 13 receives the second power-on signal, and controls, based on the second power-on signal, a corresponding battery swapping unit 10 to perform high-voltage power-on, thereby effectively achieving high-voltage power-on of the battery system 1.

In some embodiments, as shown in FIG. 5, step 110 includes step 111 and step 112.

In step 111, the VCU 2 determines whether the battery system 1 meets a high-voltage power-on condition.

In step 112, in the case where the high-voltage power-on condition is met, the VCU 2 sends the first power-on signal to the MBMU 21.

The high-voltage power-on condition may include, for example, that relays in the battery system 1 are all in an off state, and/or that a high-voltage electric device connected to the battery system 1 is not enabled.

The high-voltage electric device includes, for example, loads such as a motor, an oil pump, and an air conditioner in the vehicle. Before the high-voltage power-on, the VCU 2 needs to determine that these high-voltage electric devices are in a deactivated state, and/or that relays in the battery system 1 are all in an off state. Optionally, the high-voltage power-on condition may further include whether the vehicle is in a neutral gear or a D gear, whether any other faults are present, and the like. In this way, the risk caused by sudden startup of the high-voltage electric device after the high-voltage power-on can be reduced.

In some embodiments, the power-on method 100 further includes: determining, by the MBMU 21, the number of the plurality of battery swapping units, where in step 120, in the case where the number of the plurality of battery swapping units is equal to a preset number, the MBMU 21 sends the second power-on signal to the SBMU 13.

Before the high-voltage power-on, the MBMU 21 determines whether the number of the battery swapping units is equal to the preset number. This can reduce the risks caused by problems such as failure of the battery swapping units and improve the reliability of the power-on process of the battery system 1. For example, for a three-pack system, that is, the battery system 1 includes three battery swapping units 10, if one of the battery swapping units 10 fails, the number of currently detected battery swapping units 10 may not be equal to three, indicating that the current battery swapping system 1 does not match, and the fault needs to be reported. Only in the case where the number of the battery swapping units 10 is determined to be equal to the preset number, i.e., 3, the MBMU 21 sends the second power-on signal to the SBMU 13, so as to instruct the SBMU 13 to control the corresponding battery swapping unit to perform high-voltage power-on.

In some embodiments, the MBMU 21 may send an encoding signal to the SBMU 13 of the first battery swapping unit 10 among the plurality of battery swapping units 10. The encoding signal is used to be sequentially transmitted among the SBMUs 13 in the plurality of battery swapping units 10, so as to sequentially encode the plurality of battery swapping units 10. The MBMU 21 receives an encoding result sent by the SBMU 13 of the last battery swapping unit 10 among the plurality of battery swapping units 10, and determines, based on the encoding result, the number of the plurality of battery swapping units 10.

For example, as shown in FIG. 6, a manner similar to numbering is used among the plurality of battery swapping units 10. It is assumed that the battery system 1 is an N-pack system; that is, the battery system 1 includes N battery swapping units 10. In the process of determining the number of the current battery swapping units 10, the MBMU 21 sends an encoding signal to the SBMU 13 of the first battery swapping unit 10, and the serial number information carried by the numbering signal is 1; the SBMU 13 of the first battery swapping unit 10 continues to send the encoding signal to the SBMU 13 of the second battery swapping unit 10, and the serial number information carried by the numbering signal is updated to 2, ...; and the encoding signal is sequentially delivered among the plurality of battery swapping units 10 until the SBMU 13 of the last battery swapping unit 10 receives the encoding signal, and the serial number information carried by the numbering signal is updated to M. The SBMU 13 of the last battery swapping unit 10 sends the encoding result M to the MBMU 21, and the MBMU 21 receives the encoding result M sent by the SBMU 13 of the last battery swapping unit 10 and determines whether the current number M of the battery swapping units 10 is the preset number N. If M = N, the encoding is validated, and the high-voltage power-on can be performed normally; and if M ≠ N, the MBMU 21 reports the fault information that the battery swapping system 1 does not match.

To reduce the risk existing in the battery system 1, the MBMU 21 may determine, based on the actual situation of each battery swapping unit 10, whether to perform high-voltage power-on on each battery swapping unit. For example, in some embodiments, step 120 may include step 121 and step 122.

In step 121, the MBMU 21 determines at least one battery swapping unit 10 to be powered on among the plurality of battery swapping units 10.

In step 122, the MBMU 21 sends the second power-on signal to the SBMU 13 in the at least one battery swapping unit 10.

In some embodiments, in step 121, the MBMU 21 may determine, based on voltages of the plurality of battery swapping units 10, the at least one battery swapping unit 10 to be powered on among the plurality of battery swapping units 10.

For example, the MBMU 21 may determine, in the case where the voltage difference between a highest-voltage battery swapping unit 10 and a lowest-voltage battery swapping unit 10 among the plurality of battery swapping units 10 is greater than or equal to the voltage threshold, that the at least one battery swapping unit 10 includes a battery swapping unit 10 having a voltage difference from the highest-voltage battery swapping unit 10 less than the voltage threshold.

For another example, the MBMU 21 may determine, in the case where the voltage difference between the highest-voltage battery swapping unit 10 and the lowest-voltage battery swapping unit 10 among the plurality of battery swapping units 10 is less than or equal to the voltage threshold, that the at least one battery swapping unit 10 includes the plurality of battery swapping units 10.

Specifically, first, the highest-voltage battery swapping unit 10 among the plurality of battery swapping units 10 may be selected as one of the battery swapping units 10 to be powered on. This is because the highest-voltage battery swapping unit 10 also has the highest available electric energy, which is beneficial to the driving range of the vehicle. Therefore, the highest-voltage battery swapping unit 10 can be preferentially selected as one of the battery swapping units 10 to be powered on.

Then, the voltage difference between the voltages of the lowest-voltage battery swapping unit 10 and the highest-voltage battery swapping unit 10 is calculated, and the magnitude relationship between the voltage difference and the preset voltage threshold is determined. The voltage threshold may be determined based on the safety performance requirements of the battery system 1. If the voltage difference between the two battery swapping units 10 is greater than the voltage threshold, a large current flow may occur between the two battery swapping units, thereby increasing the risk of the battery system 1.

If the voltage difference between the highest-voltage battery swapping unit 10 and the lowest-voltage battery swapping unit 10 among the plurality of battery swapping units 10 is less than or equal to the voltage threshold, the voltage differences between other battery swapping units 10 and the highest-voltage battery swapping unit 10 are also less than or equal to the voltage threshold. Therefore, the plurality of battery swapping units 10 can be subject to high-voltage power-on simultaneously; that is, the at least one battery swapping unit 10 to be powered on includes the plurality of battery swapping units 10.

If the voltage difference between the highest-voltage battery swapping unit 10 and the lowest-voltage battery swapping unit 10 among the plurality of battery swapping units 10 is greater than or equal to the voltage threshold, in order to reduce the risk existing in the battery system 1, it is possible to select only the battery swapping unit 10 having a voltage difference from the highest-voltage battery swapping unit 10 within a predetermined range as the battery swapping unit 10 that requires high-voltage power-on; that is, the at least one battery swapping unit 10 to be powered on includes the battery swapping unit 10 having a voltage difference from the highest-voltage battery swapping unit 10 less than the voltage threshold.

The battery swapping unit 10 further includes a slave high-voltage box 12 connected to the battery 11, and the slave high-voltage box 12 is provided with a first relay unit, including, for example, a main positive relay and/or a main negative relay on a main loop of the battery 11. The second power-on signal is specifically used to instruct the SBMU 13 to control the first relay unit in the corresponding battery swapping unit to close, so as to achieve high-voltage power-on of the battery swapping unit 10.

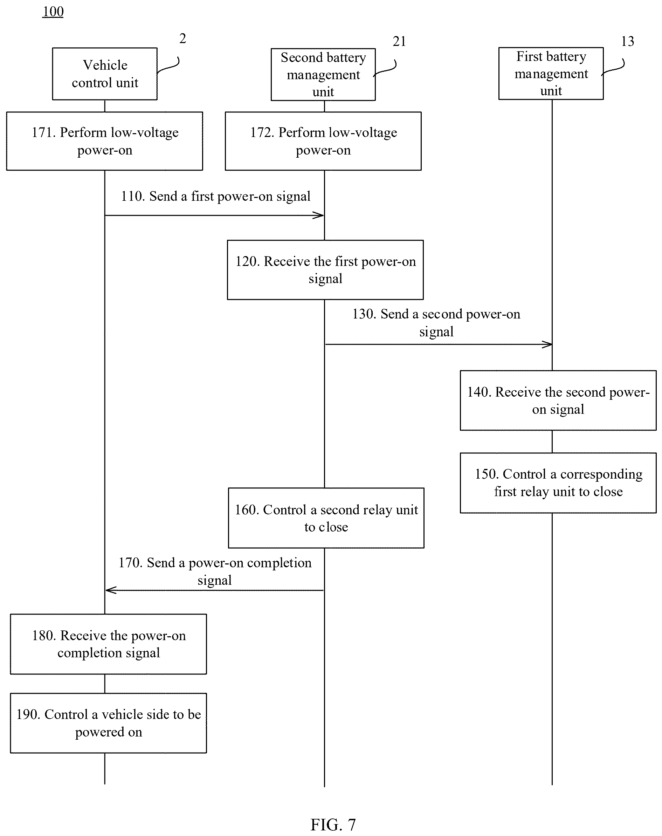

For example, as shown in FIG. 7, in step 140, the SBMU 13 receives the second power-on signal sent by the MBMU 21.

In step 150, the SBMU 13 controls, based on the second power-on signal, the corresponding battery swapping unit 10 to perform high-voltage power-on. For example, the SBMU 13 controls the first relay unit in the corresponding battery swapping unit 10 to close.

In some embodiments, the battery system 1 further includes a master high-voltage box 20, the slave high-voltage box 12 is connected to the master high-voltage box 20 via a pluggable electrical connector 30, and the master high-voltage box 20 is provided with a second relay unit, including, for example, a main positive relay and/or a main negative relay connected in series on the main loop of the battery 11.

As shown in FIG. 7, in step 160, the MBMU 21 controls the master high-voltage box 20 to perform high-voltage power-on. For example, the MBMU 21 controls the second relay unit in the master high-voltage box 20 to close after the SBMU 13 controls the first relay unit in the slave high-voltage box 12 of at least one battery swapping unit 10 to close.

After the relays of the first relay unit in the slave high-voltage box 12 of the respective battery swapping units 10 to be powered on are all closed, the MBMU 21 controls the relays of the second relay unit in the master high-voltage box 20 to close, such that the energy provided by the batteries 11 of the respective battery swapping units 10 can simultaneously reach the connected high-voltage electric device, thereby providing a more stable high-voltage signal for the connected high-voltage electric device. It can be understood that the first relay units in the slave high-voltage boxes 12 of the respective battery swapping units 10 to be powered on may be closed simultaneously, or may be closed sequentially according to an order.

In some embodiments, the power-on method 100 further includes step 170, step 180, and step 190.

In step 170, after the MBMU 21 controls the second relay unit in the master high-voltage box 20 to close, the MBMU 21 sends a power-on completion signal to the VCU 2.

In step 180, the VCU 2 receives the power-on completion signal sent by the MBMU 21.

The power-on completion signal is used to indicate that the battery system 1 has completed the high-voltage power-on.

In step 190, the VCU 2 controls, based on the power-on completion signal, a relay in a main loop between the battery system 1 and the high-voltage electric device to close.

Upon completion of the high-voltage power-on of the battery system 1, the MBMU 21 needs to notify the VCU 2 that the battery side has completed the high-voltage power-on, such that the VCU 2 controls the vehicle side to perform the high-voltage power-on. Upon receiving the power-on completion signal sent by the MBMU 21 and determining that the battery system 1 has completed the high-voltage power-on, the VCU 2 controls the relay in the main loop between the battery system 1 and the high-voltage electric device to close. The high-voltage power-on is performed following the "battery first, vehicle second" sequence; that is, the high-voltage power-on is first performed on the battery system 1, and then the high-voltage power-on is performed on the high-voltage electric device on the vehicle side. This can reduce the risk caused by situations such as sudden startup of the high-voltage electric device.

In some embodiments, the power-on method 100 further includes: sending, by the MBMU 21, information on an allowable power P of the battery system 1. The allowable power P of the battery system 1 is a sum of the allowable powers of the plurality of battery swapping units 10.

The MBMU 21 needs to provide the information on the allowable power P thereof to the outside. For example, the battery system 1 includes N battery swapping units 10, and the allowable powers of the N battery swapping units 10 are P1, P2, ..., and Pn, respectively, then P = P1 + P2 + ... + Pn. It can be understood that if any battery swapping unit 10 fails to meet the above voltage threshold requirements or any battery swapping unit 10 is powered off due to faults or other reasons in the N battery swapping units 10, the allowable power P does not include the allowable powers corresponding to such battery swapping units 10; that is, the allowable power P is the sum of the allowable powers of the remaining battery swapping units 10.

For example, the MBMU 21 may send the information on the allowable power P to the VUC 2, such that the VCU 2 knows the output power that the battery system 1 can provide. For another example, the MBMU 21 may send the information on the allowable power P to the charging apparatus, such that the charging apparatus can provide an appropriate power when simultaneously charging the plurality of battery swapping units 10 in the battery system 1.

In some embodiments, as shown in FIG. 6, the power-on method 100 further includes step 171 and step 172.

In step 171, the VCU 2 receives a wake-up signal, and performs low-voltage power-on based on the wake-up signal.

The low-voltage power-on is also referred to as low voltage activation; that is, the low-voltage line in the battery system 1 is enabled to be connected.

Since low-voltage electric modules such as the VCU 2 require a low-voltage signal as their power supply, before the VCU 2 controls the vehicle side to perform high-voltage power-on, the VCU 2 needs to perform low-voltage power-on based on the received wake-up signal.

In step 172, the MBMU 21 receives the wake-up signal, and performs low-voltage power-on based on the wake-up signal.

Since the low-voltage electric modules such as the MBMU 21 and the SBMU 13 require a low-voltage signal as their power supply, before the MBMU 21 controls the battery system 1 to perform high-voltage power-on, the MBMU 21 needs to perform low-voltage power-on based on the received wake-up signal.

The wake-up signals received by the VCU 2 and the MBMU 21 may be, for example, signals triggered when the vehicle is started by using a vehicle key.

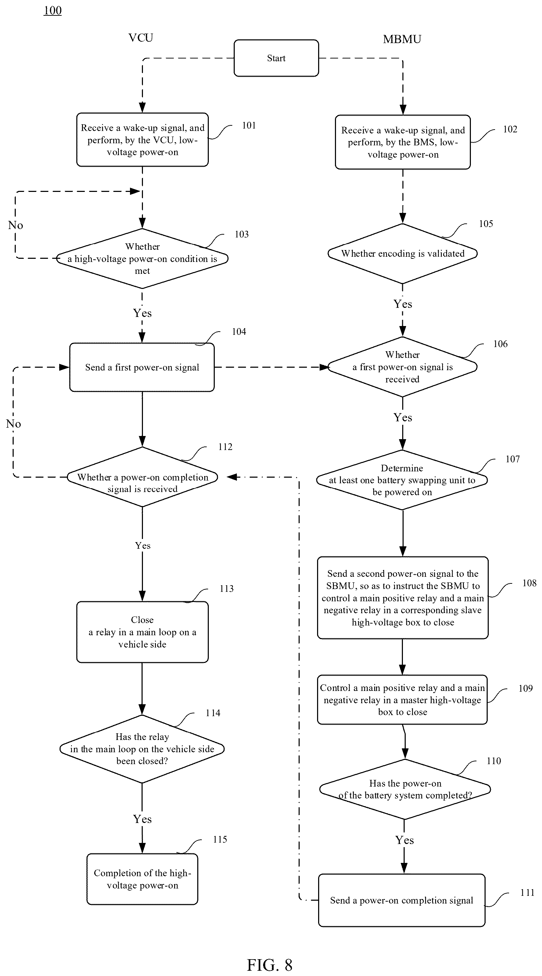

FIG. 8 is a flowchart of a possible specific implementation of the power-on method 100 shown in FIGs. 5 and 7. As an example, as shown in FIG. 8, the power-on method 100 may include some or all of steps 101 to 116.

In step 101, the VCU 2 receives a wake-up signal and performs low-voltage power-on.

In step 102, the MBMU 21 receives the wake-up signal and performs the low-voltage power-on.

In step 103, the VCU 2 determines whether the high-voltage power-on condition is currently met.

In the case where the high-voltage power-on condition is met, step 104 is executed.

In step 104, the VCU 2 sends a first power-on signal to the MBMU 21.

In step 105, the MBMU 21 encodes the plurality of battery swapping units 10, and determines whether the number of the plurality of battery swapping units 10 encoded is equal to the preset number.

In step 106, the MBMU 21 detects whether the first power-on signal sent by the VCU 2 has been received.

If the encoding of the plurality of battery swapping units 10 is validated in step 105, and the MBMU 21 receives the first power-on signal in step 106, step 107 is executed. If the encoding of the plurality of battery swapping units 10 fails to be validated, the MBMU 21 reports the fault information that the battery system 1 does not match.

In step 107, the MBMU 21 determines at least one battery swapping unit 10 to be powered on among the plurality of battery swapping units 10.

For example, at least one battery swapping unit 10 to be powered on may be determined based on the voltages of the plurality of battery swapping units 10. The voltage difference between any two battery swapping units 10 within the at least one battery swapping unit 10 is less than the voltage threshold.

In step 108, the MBMU 21 sends a second power-on signal to the SBMU 13 corresponding to the battery swapping unit 10 to be powered on.

After receiving the second power-on signal, the SBMU 13 controls, based on the second power-on signal, the main positive relay and the main negative relay that are connected in series with the battery 11 in the corresponding slave high-voltage box 12 to close, so as to complete the high-voltage power-on in the slave high-voltage box 12, thereby connecting the high-voltage line in the slave high-voltage box 12.

In step 109, the MBMU 21 controls the main positive relay and the main negative relay that are connected in series with the battery 11 in the master high-voltage box 20 to close, so as to complete the high-voltage power-on in the master high-voltage box 20, thereby connecting the high-voltage line in the master high-voltage box 20.

In step 110, the MBMU 21 determines whether the battery system 1 has completed the high-voltage power-on.

If the battery system 1 has completed the high-voltage power-on, step 111 is executed; otherwise, the high-voltage power-on of the battery system 1 fails.

In step 111, the MBMU 21 sends a power-on completion signal to the VCU 2.

In step 112, the VCU 2 detects whether the power-on completion signal sent by the MBMU 21 has been received.

If the VCU 2 receives the power-on completion signal in step 112, step 113 is executed.

In step 113, the VCU 2 controls the relay in the main loop between the battery system 1 and the high-voltage electric device to close, thereby performing high-voltage power-on on the vehicle side.

In step 114, the VCU 2 determines whether the relay in the main loop on the vehicle side is closed.

If the relays in the main loop on the vehicle side are all closed, the high-voltage power-on is completed on the vehicle side, and step 115 is executed; otherwise, the high-voltage power-on on the vehicle side fails.

In step 115, the high-voltage power-on is completed.

The embodiments of the present application further provide a high-voltage box applied to the battery system 1. The high-voltage box is a master high-voltage box 20 of the battery system 1. The battery system 1 further includes a plurality of battery swapping units 10 connected in parallel. Each battery swapping unit 10 includes a battery 11 and a slave high-voltage box 12 connected to the battery. The master high-voltage box 20 is connected to the slave high-voltage box 12 via a pluggable electrical connector 30. The slave high-voltage box 12 includes a first battery management unit 13 of the battery 11, and the master high-voltage box 20 includes a second battery management unit 21 connected to the first battery management units 13 in the plurality of battery swapping units 10.

According to the embodiments of the present application, the slave high-voltage boxes 12 in the plurality of battery swapping units 10 connected in parallel and the master high-voltage box 20 are connected via the pluggable electrical connector 30. Therefore, the plurality of battery swapping units 10 can be disassembled independently, and the plurality of battery swapping units 10 do not need to be bound for use, allowing only a portion of the battery swapping units 10 to be swapped and charged. This supports the mixed use of the battery swapping units 10, thereby resulting in high battery swapping efficiency and facilitating the construction and operation of the battery swapping station.

In some embodiments, the electrical connector 30 includes a high-voltage interface and a low-voltage interface. The high-voltage line in the master high-voltage box 20 is connected to the high-voltage line in the slave high-voltage box 12 via the high-voltage interface, and the low-voltage line in the slave main voltage box is connected to the low-voltage line in the slave high-voltage box 12 via the low-voltage interface.

In some embodiments, the master high-voltage box 20 and/or the slave high-voltage box 12 further includes an insulation detector, the insulation detector is configured to detect the insulation impedance to ground of the high-voltage bus, and the insulation detector in the master high-voltage box 20 and the insulation detector in the slave high-voltage box 12 are configured to be prevented from being enabled simultaneously.

In some embodiments, in the case where the battery system 1 is assembled in the electric apparatus, the insulation detector in the master high-voltage box 20 is configured to be enabled, and the insulation detector in the slave high-voltage box 12 is configured to be prevented from being enabled; and/or in the case where the battery system 1 is charged in the battery swapping station, the insulation detector in the slave high-voltage box 12 is configured to be enabled.

In some embodiments, the master high-voltage box 20 and/or the slave high-voltage box 12 further includes a high-voltage detection circuit. The high-voltage detection circuit is configured to detect the voltage of the high-voltage bus and/or the voltage across a relay.

In some embodiments, the electrical connector 30 is arranged on the outer frame of the battery swapping unit 10, the high-voltage interface on the electrical connector 30 is configured to connect to the main loop connector E3 of the slave high-voltage box 12, and the low-voltage interface on the electrical connector 30 is configured to connect to the external low-voltage connector E4 of the slave high-voltage box 12.

In some embodiments, the master high-voltage box 20 further includes a main positive relay K3 connected to the positive electrode of the master high-voltage box 20, and/or a main negative relay K4 connected to the negative electrode of the master high-voltage box 20.

In a possible implementation, the master high-voltage box 20 further includes a charging positive relay K5 connected to the positive electrode of the master high-voltage box 20, and/or a charging negative relay K6 connected to the negative electrode of the master high-voltage box 20. The charging positive relay K5 and the charging negative relay K6 are configured to connect to the socket of the electric apparatus, so as to charge the battery system 1.

In some embodiments, the master high-voltage box 20 further includes at least one high-voltage connector and at least one low-voltage connector. The high-voltage connector includes a subsystem connector E5 for connecting the slave high-voltage box 12 and a main loop connector E6 for connecting the vehicle control unit 2. The low-voltage connector includes a low-voltage connector E8 for communicating with the slave high-voltage box 12 and a low-voltage connector E9 for communicating with the vehicle control unit 2.

In some embodiments, the master high-voltage box 20 and/or the slave high-voltage box 12 further includes a manual service disconnect, and a fuse unit is integrated on the manual service disconnect.

It can be understood that, for specific details of the master high-voltage box 20, reference may be made to the above description of the battery system 1, which will not be repeated herein for brevity.

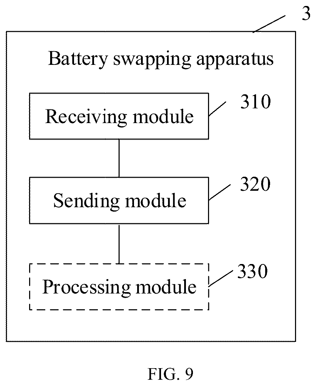

The embodiments of the present application further provide a battery swapping apparatus 3 applied to a battery system 1. The battery system 1 includes a plurality of battery swapping units 10 connected in parallel. Each battery swapping unit 10 includes a battery 11 and a first battery management unit 13 of the battery, and the battery system 1 further includes a second battery management unit 21 connected to the first battery management units 13 in the plurality of battery swapping units 10. The battery swapping apparatus 3 may be, for example, the second battery management unit 21. In a schematic block diagram of the battery swapping apparatus 3 shown in FIG. 9, the battery swapping apparatus 3 includes a receiving module 310 and a sending module 320. The receiving module 310 is configured to receive a first power-on signal sent by the vehicle control unit 2. The sending module 320 is configured to send, in response to the first power-on signal, a second power-on signal to the first battery management unit 13. The second power-on signal is used to instruct the first battery management unit 13 to control the corresponding battery swapping unit 10 to perform high-voltage power-on.

In some embodiments, the battery swapping apparatus 3 further includes a processing module 330. The processing module 330 is configured to determine the number of the plurality of battery swapping units 10. The sending module 320 is specifically configured to send, in the case where the number of the plurality of battery swapping units 10 is equal to the preset number, the second power-on signal to the first battery management unit 13.

In some embodiments, the processing module 330 is specifically configured to: control the sending module 320 to send an encoding signal to the first battery management unit 13 in the first battery swapping unit 10 among the plurality of battery swapping units 10, where the encoding signal is used to be sequentially transmitted among the first battery management units 13 in the plurality of battery swapping units 10, so as to sequentially encode the plurality of battery swapping units 10; control the receiving module to receive an encoding result sent by the first battery management unit 13 of the last battery swapping unit 10 among the plurality of battery swapping units 10; and determine the number of the plurality of battery swapping units 10 based on the encoding result.

In some embodiments, the processing module 330 is further configured to determine at least one battery swapping unit 10 to be powered on among the plurality of battery swapping units 10; and the sending module 320 is specifically configured to send the second power-on signal to the first battery management unit 13 in the at least one battery swapping unit 10.

In some embodiments, the processing module 330 is specifically configured to determine, based on voltages of the plurality of battery swapping units 10, the at least one battery swapping unit 10 to be powered on among the plurality of battery swapping units 10.

In some embodiments, the processing module 330 is specifically configured to determine, in the case where the voltage difference between a highest-voltage battery swapping unit 10 and a lowest-voltage battery swapping unit 10 among the plurality of battery swapping units 10 is greater than or equal to the voltage threshold, that the at least one battery swapping unit 10 includes a battery swapping unit 10 having a voltage difference from the highest-voltage battery swapping unit 10 less than the voltage threshold.

In some embodiments, the processing module 330 is specifically configured to determine, in the case where the voltage difference between the highest-voltage battery swapping unit 10 and the lowest-voltage battery swapping unit 10 among the plurality of battery swapping units 10 is less than or equal to the voltage threshold, that the at least one battery swapping unit 10 includes the plurality of battery swapping units 10.

In some embodiments, the battery swapping unit 10 further includes a slave high-voltage box 12 connected to the battery 11, and the slave high-voltage box 12 includes a first relay unit. The second power-on signal is specifically configured to instruct the first battery management unit 13 to control the corresponding first relay unit to close.

In some embodiments, the battery system 1 further includes a master high-voltage box 20, the slave high-voltage box 12 is connected to the master high-voltage box 20 via a pluggable electrical connector 30, the master high-voltage box 20 includes a second relay unit, and the processing module 330 is further configured to control the second relay unit to close after the first relay unit in the at least one battery swapping unit 10 is closed.

In some embodiments, the sending module 320 is further configured to send a power-on completion signal to the vehicle control unit 2 after the second relay unit is closed.

In some embodiments, the sending module 320 is further configured to send information on the allowable power of the battery system 1. The allowable power of the battery system 1 is a sum of the allowable powers of the plurality of battery swapping units 10.

In some embodiments, the receiving module 310 is further configured to receive a wake-up signal; and the processing module 330 is further configured to perform, based on the wake-up signal, low-voltage power-on on the second battery management unit 21.

It can be understood that the battery swapping apparatus 3 is configured to execute the part executed by the second battery management unit 21 in the above power-on method 100. For the specific details of the battery swapping apparatus 3, reference may be made to the above description of the power-on method 100, which will not be repeated herein for brevity.

The embodiments of the present application further provide a battery swapping apparatus applied to a battery system 1. The battery system 1 includes a plurality of battery swapping units 10 connected in parallel. Each battery swapping unit 10 includes a battery 11 and a first battery management unit 13 of the battery, and the battery system 1 further includes a second battery management unit 21 connected to the first battery management units 13 in the plurality of battery swapping units 10. The battery swapping apparatus may be, for example, the vehicle control unit 2. The battery swapping apparatus includes a processing module and a sending module. The processing module is configured to determine whether the battery system 1 meets the high-voltage power-on condition. The sending module is configured to send, in the case where the high-voltage power-on condition is met, a first power-on signal to the second battery management unit 21. The first power-on signal is used to instruct the second battery management unit 21 to control the battery system 1 to perform high-voltage power-on.

In some embodiments, the high-voltage power-on condition includes at least one of the following: relays in the battery system 1 are all in an off state; and the high-voltage electric device connected to the battery system 1 is not enabled.

In some embodiments, the battery swapping apparatus further includes a receiving module. The receiving module is configured to receive the power-on completion signal sent by the second battery management unit 21, where the power-on completion signal is used to indicate that the battery system 1 has completed the high-voltage power-on; and the processing module is further configured to control, based on the power-on completion signal, the relay in the main loop between the battery system 1 and the high-voltage electric device to close.

In some embodiments, the battery swapping apparatus further includes a receiving module. The receiving module is configured to receive a wake-up signal; and the processing module is further configured to perform, based on the wake-up signal, low-voltage power-on on the vehicle control unit 2.

It can be understood that the battery swapping apparatus is configured to execute the part executed by the vehicle control unit 2 in the above power-on method 100. For the specific details of the battery swapping apparatus, reference may be made to the above description of the power-on method 100, which will not be repeated herein for brevity.

The embodiments of the present application further provide a battery swapping device. The battery swapping device includes a processor and a memory. The memory is configured to store a computer program, and the processor is configured to call and run the computer program stored in the memory, so as to execute the part executed by the second battery management unit 21 or the vehicle control unit 2 in the power-on method 100 according to any one of the above embodiments.

The embodiments of the present application further provide a chip. The chip includes a processor. The processor is configured to call and run a computer program from a memory, such that a device installed with the chip executes the part executed by the second battery management unit 21 or the vehicle control unit 2 in the power-on method 100 according to any one of the above embodiments.

The embodiments of the present application further provide a computer-readable storage medium configured to store a computer program. The computer program causes a computer to execute the part executed by the second battery management unit 21 or the vehicle control unit 2 in the power-on method 100 according to any one of the above embodiments.

The embodiments of the present application further provide an electric apparatus. The electric apparatus includes the battery system 1 according to any one of the above embodiments and a high-voltage electric device connected to the battery system 1. The battery system 1 is configured to supply power to the high-voltage electric device.

When the electric apparatus is powered by the battery system 1, the electric apparatus may be, for example, a heavy truck. Optionally, the heavy truck may be a 6*4 tractor or an 8*4 dump truck. The vehicle model of the heavy truck is not limited in the embodiments of the present application. Certainly, the battery system 1 according to the embodiments of the present application may also be applied to a passenger vehicle or another single-pack battery swapping vehicle model.

It is to be noted that the various embodiments and/or the technical features of the embodiments described in the present application may be arbitrarily combined without conflict, and the combined technical solutions also fall within the protection scope of the present application.

Those of ordinary skill in the art will recognize that the units and algorithm steps of various examples described in conjunction with the embodiments disclosed herein can be implemented in electronic hardware, or a combination of computer software and electronic hardware. Whether these functions are performed in hardware or software depends on the particular application and design constraints of the technical solutions. Those skilled in the art may implement the described functions in varying ways for each particular application, but such implementation should not be interpreted as departing from the scope of the present application.

Those skilled in the art may clearly understand that, for the convenience and brevity in the description, reference may be made to the corresponding processes in the above method embodiments for the specific working processes of the systems, apparatuses, and units described above, which will not be repeated herein.

In the several embodiments provided in the present application, it should be understood that the disclosed systems, apparatuses, and methods may be implemented in other ways. For example, the above-described apparatus embodiments are merely illustrative. For example, the division of the units is only a division based on logical function, and it can be implemented in other ways in actual situations. For example, multiple units or components may be combined or integrated into another system, or some features may be omitted or not executed. In addition, the coupling, direct coupling, or communication connection between each other that is shown or discussed may be indirect coupling or communication connection through some interfaces, apparatuses, or units, and it may be in electrical, mechanical, or other forms.

The units described as separate components may or may not be physically separate, and components displayed as units may or may not be physical units; that is, they may be located in one place or distributed across a plurality of network units. Some or all of the units may be selected according to actual needs to achieve the purpose of the solutions of the embodiments.

## Claims

1. A power-on method for a battery system, wherein the battery system comprises a plurality of battery swapping units connected in parallel, wherein each battery swapping unit comprises a battery and a first battery management unit of the battery, the battery system further comprises a second battery management unit connected to the first battery management units in the plurality of battery swapping units, the power-on method is performed by the second battery management unit, and the power-on method comprises:
receiving a first power-on signal sent by a vehicle control unit; and
in response to the first power-on signal, sending a second power-on signal to the first battery management unit, wherein the second power-on signal is used to instruct the first battery management unit to control a corresponding battery swapping unit to perform high-voltage power-on.

2. The power-on method according to claim 1, wherein the power-on method further comprises:
determining a number of the plurality of battery swapping units;
wherein sending the second power-on signal to the first battery management unit comprises:
in a case where the number of the plurality of battery swapping units is equal to a preset number, sending the second power-on signal to the first battery management unit.

3. The power-on method according to claim 2, wherein determining the number of the plurality of battery swapping units comprises:
sending an encoding signal to a first battery management unit of a first battery swapping unit among the plurality of battery swapping units, wherein the encoding signal is used to be sequentially transmitted among the first battery management units in the plurality of battery swapping units, so as to sequentially encode the plurality of battery swapping units;
receiving an encoding result sent by a first battery management unit of a last battery swapping unit among the plurality of battery swapping units; and
determining, based on the encoding result, the number of the plurality of battery swapping units.

4. The power-on method according to any one of claims 1 to 3, wherein sending the second power-on signal to the first battery management unit comprises:
determining at least one battery swapping unit to be powered on among the plurality of battery swapping units; and
sending the second power-on signal to a first battery management unit in the at least one battery swapping unit.

5. The power-on method according to claim 4, wherein determining the at least one battery swapping unit to be powered on among the plurality of battery swapping units comprises:
determining, based on voltages of the plurality of battery swapping units, the at least one battery swapping unit to be powered on among the plurality of battery swapping units.

6. The power-on method according to claim 5, wherein determining, based on the voltages of the plurality of battery swapping units, the at least one battery swapping unit to be powered on among the plurality of battery swapping units comprises:
in a case where a voltage difference between a highest-voltage battery swapping unit and a lowest-voltage battery swapping unit among the plurality of battery swapping units is greater than or equal to a voltage threshold, determining that the at least one battery swapping unit comprises a battery swapping unit having a voltage difference from the highest-voltage battery swapping unit less than the voltage threshold.

7. The power-on method according to claim 5 or 6, wherein determining, based on the voltages of the plurality of battery swapping units, the at least one battery swapping unit to be powered on among the plurality of battery swapping units comprises:
in a case where the voltage difference between the highest-voltage battery swapping unit and the lowest-voltage battery swapping unit among the plurality of battery swapping units is less than or equal to the voltage threshold, determining that the at least one battery swapping unit comprises the plurality of battery swapping units.

8. The power-on method according to any one of claims 4 to 7, wherein the battery swapping unit further comprises a slave high-voltage box connected to the battery, and the slave high-voltage box comprises a first relay unit, wherein the second power-on signal is specifically used to instruct the first battery management unit to control a corresponding first relay unit to close.

9. The power-on method according to claim 8, wherein the battery system further comprises a master high-voltage box, the slave high-voltage box is connected to the master high-voltage box via a pluggable electrical connector, the master high-voltage box comprises a second relay unit, and the power-on method further comprises:
controlling the second relay unit to close after the first relay unit in the at least one battery swapping unit is closed.

10. The power-on method according to claim 9, wherein the power-on method further comprises:
sending a power-on completion signal to the vehicle control unit after the second relay unit is closed.

11. The power-on method according to any one of claims 1 to 10, wherein the power-on method further comprises:
sending information on an allowable power of the battery system, wherein the allowable power of the battery system is a sum of allowable powers of the plurality of battery swapping units.

12. The power-on method according to any one of claims 1 to 11, wherein the power-on method further comprises:
receiving a wake-up signal; and
performing, based on the wake-up signal, low-voltage power-on on the second battery management unit.

13. A battery system, comprising:
a plurality of battery swapping units connected in parallel, wherein each battery swapping unit comprises a battery and a slave high-voltage box connected to the battery, and the slave high-voltage box comprises a first battery management unit of the battery; and
a master high-voltage box, wherein the slave high-voltage box is connected to the master high-voltage box via a pluggable electrical connector, and the master high-voltage box comprises a second battery management unit connected to the first battery management units in the plurality of battery swapping units.

14. The battery system according to claim 13, wherein the electrical connector comprises a high-voltage interface and a low-voltage interface, a high-voltage line in the slave high-voltage box is connected to a high-voltage line in the master high-voltage box via the high-voltage interface, and a low-voltage line in the slave high-voltage box is connected to a low-voltage line in the master high-voltage box via the low-voltage interface.

15. The battery system according to claim 13 or 14, wherein the master high-voltage box and/or the slave high-voltage box further comprises an insulation detector, the insulation detector is configured to detect insulation impedance to ground of a high-voltage bus, and the insulation detector in the master high-voltage box and the insulation detector in the slave high-voltage box are configured to be prevented from being enabled simultaneously.

16. The battery system according to claim 15, wherein in a case where the battery system is assembled in an electric apparatus, the insulation detector in the master high-voltage box is configured to be enabled, and the insulation detector in the slave high-voltage box is configured to be prevented from being enabled; and/or in a case where the battery system is charged in a battery swapping station, the insulation detector in the slave high-voltage box is configured to be enabled.

17. The battery system according to any one of claims 13 to 16, wherein the master high-voltage box and/or the slave high-voltage box further comprises a high-voltage detection circuit, and the high-voltage detection circuit is configured to detect a voltage of the high-voltage bus and/or a voltage across a relay.

18. The battery system according to any one of claims 13 to 17, wherein the slave high-voltage box further comprises a main positive relay connected to a positive electrode of the slave high-voltage box, and/or a main negative relay connected to a negative electrode of the slave high-voltage box.

19. The battery system according to any one of claims 13 to 18, wherein the slave high-voltage box comprises at least one high-voltage connector and at least one low-voltage connector, the high-voltage connector comprises a main loop connector for connecting the master high-voltage box and a branch connector for connecting the battery on each branch, and the low-voltage connector comprises an external low-voltage connector for connecting the master high-voltage box and a low-voltage input/output connector for connecting a cell sampling circuit of the battery on each branch.

20. The battery system according to claim 19, wherein the electrical connector is arranged on an outer frame of the battery swapping unit, the high-voltage interface on the electrical connector is configured to connect to the main loop connector of the slave high-voltage box, and the low-voltage interface on the electrical connector is configured to connect to the external low-voltage connector of the slave high-voltage box.

21. The battery system according to any one of claims 13 to 20, wherein a current sensor is arranged on each branch in the slave high-voltage box, and the current sensor is configured to detect a current on a corresponding branch.

22. The battery system according to any one of claims 13 to 21, wherein the master high-voltage box further comprises a main positive relay connected to a positive electrode of the master high-voltage box, and/or a main negative relay connected to a negative electrode of the master high-voltage box.

23. The battery system according to any one of claims 13 to 22, wherein the master high-voltage box further comprises a charging positive relay connected to the positive electrode of the master high-voltage box, and/or a charging negative relay connected to the negative electrode of the master high-voltage box, and the charging positive relay and the charging negative relay are configured to connect to a socket of the electric apparatus, so as to charge the battery system.

24. The battery system according to any one of claims 13 to 23, wherein the master high-voltage box further comprises at least one high-voltage connector and at least one low-voltage connector, the high-voltage connector comprises a subsystem connector for connecting the slave high-voltage box and a main loop connector for connecting a vehicle control unit, and the low-voltage connector comprises a low-voltage connector for communicating with the slave high-voltage box and a low-voltage connector for communicating with the vehicle control unit.

25. The battery system according to any one of claims 13 to 24, wherein the master high-voltage box and/or the slave high-voltage box further comprises a manual service disconnect, and a fuse unit is integrated on the manual service disconnect.

26. A battery swapping apparatus configured to perform the power-on method according to any one of claims 1 to 12.

27. A battery swapping device, comprising a processor and a memory, wherein the memory is configured to store a computer program, and the processor is configured to call and run the computer program stored in the memory, so as to perform the power-on method according to any one of claims 1 to 12.

28. A chip, comprising a processor, wherein the processor is configured to call and run a computer program from a memory, such that a device installed with the chip performs the power-on method according to any one of claims 1 to 12.

29. A computer-readable storage medium configured to store a computer program,
wherein the computer program causes a computer to perform the power-on method according to any one of claims 1 to 12.

30. An electric apparatus, comprising the battery system according to any one of claims 13 to 25 and a high-voltage electric device connected to the battery system, wherein the battery system is configured to supply power to the high-voltage electric device.
